# EUROPÄISCHE PATENTSCHRIFT

(11) **EP 3 046 927 B1**
(45) Veröffentlichungstag und Bekanntmachung des Hinweises auf die Patenterteilung: **30.01.2019**
(21) Anmeldenummer: 14752791.5
(22) Anmeldetag: 19.08.2014
(51) Int. Cl.: C07F 15/00, C09K 11/00, H01L 51/50, H05B 33/14, C09K 11/02, C09K 11/06, H01L 51/00

(54) **POLYCYCLISCHE PHENYL-PYRIDIN IRIDIUMKOMPLEXE UND DERIVATE DAVON FÜR OLED**
POLYCYCLIC PHENYLPYRIDINE IRIDIUM COMPLEXES AND DERIVATIVES THEREOF FOR OLEDS
COMPLEXES D'IRIDIUM PHÉNYL-PYRIDINE POLYCYCLIQUE ET DÉRIVÉS POUR OLED DESDITS COMPLEXES

(30) Priorität: 17.09.2013 EP 13004552
(43) Veröffentlichungstag der Anmeldung: 27.07.2016
(73) Patentinhaber: Merck Patent GmbH, 64293 Darmstadt (DE)
(72) Erfinder: HAYER, Anna, 64293 Darmstadt (DE); JOOSTEN, Dominik, 60487 Frankfurt am Main (DE); HEIL, Holger, 60389 Frankfurt am Main (DE); ANEMIAN, Rémi Manouk, Seoul 657-169 (KR); DE NONANCOURT, Claire, 55300 Loupmont (FR)
(86) Internationale Anmeldenummer: PCT/EP2014/002276
(87) Internationale Veröffentlichungsnummer: WO 2015/039723

(56) Entgegenhaltungen:
- WO-A1-02/060910
- WO-A1-2011/141120
- WO-A1-2012/023545
- WO-A2-2008/073440
- WO-A2-2013/072740
- US-A1- 2008 280 163
- ANDREAS HOHENLEUTNER ET AL: "Rapid Combinatorial Synthesis and Chromatography Based Screening of Phosphorescent Iridium Complexes for Solution Processing", ADVANCED FUNCTIONAL MATERIALS, WILEY - V C H VERLAG GMBH & CO. KGAA, DE, Bd. 22, Nr. 16, 21. August 2012 (2012-08-21), Seiten 3406-3413, XP001581932, ISSN: 1616-301X, DOI: DOI: 10.1002/ADFM.201200397 [gefunden am 2012-05-08]
- DAVID L. ROCHESTER ET AL: "Localised to intraligand charge-transfer states in cyclometalated platinum complexes: an experimental and theoretical study into the influence of electron-rich pendants and modulation of excited states by ion binding", DALTON TRANSACTIONS, Nr. 10, 2009, Seite 1728, XP0055148243, ISSN: 1477-9226, DOI: 10.1039/b816375h

## Beschreibung

Die vorliegende Erfindung betrifft Metallkomplexe für die Verwendung in elektronischen Vorrichtungen sowie elektronische Vorrichtungen, insbesondere organische Elektrolumineszenzvorrichtungen, enthaltend diese Metallkomplexe, insbesondere als Emitter.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien häufig phosphoreszierende metallorganische Komplexe eingesetzt. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer. Weiterhin weisen viele phosphoreszierende Emitter keine hohe Löslichkeit für eine Verarbeitung aus Lösung auf, so dass es auch hier weiteren Verbesserungsbedarf gibt.

In phosphoreszierenden OLEDs werden als Triplettemitter insbesondere Iridium- und Platinkomplexe verwendet, welche üblicherweise als cyclometallierte Komplexe eingesetzt werden. Dabei sind die Liganden häufig Derivate von Phenylpyridin für grüne und gelbe Emission bzw. Derivate von Phenylchinolin oder Phenylisochinolin für rote Emission. Jedoch ist die Löslichkeit derartiger Komplexe häufig gering, was eine Verarbeitung aus Lösung erschwert oder gänzlich verhindert.

Aus dem Stand der Technik sind Iridiumkomplexe bekannt, welche am Phenylring des Phenylpyridinliganden in para-Position zur Koordination an das Metall mit einer gegebenenfalls substituierten Carbazolgruppe (WO 2012/007103, WO 2013/072740) oder Indenocarbazolgruppe (WO 2011/141120) substituiert sind. Jedoch gibt es auch hier noch weiteren Verbesserungsbedarf in Bezug auf die Löslichkeit sowie die Farbreinheit, also die Breite der Emission, und die Photolumineszenzquanteneffizienz der Komplexe. Auch aus A. Hohenleutner et al. (Advanced Functional Materials 2012, 22(16), 3406), WO 2008/073440, D. L. Rochester et al. (Dalton Transactions 2009, 10, 1728), WO 2002/060910, US 2008/0280163 und WO 2012/023545 sind weitere Komplexe bekannt, die mit einer Triphenylaminanalogen Gruppe substitiuert sind, wobei keiner dieser Komplexe zwei oder drei verbrückende Gruppen zwischen den Phenylgruppen der Triphenylamin-Einheit aufweist.

Überraschend wurde gefunden, dass bestimmte, unten näher beschriebene Metallchelatkomplexe eine verbesserte Farbreinheit der Emission aufweisen. Weiterhin weisen diese Komplexe eine gute Löslichkeit auf und zeigen bei Verwendung in einer organischen Elektrolumineszenzvorrichtung gute Eigenschaften hinsichtlich der Effizienz und der Lebensdauer. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

M(L)ₙ(L')ₘ Formel (1)

wobei die Verbindung der allgemeinen Formel (1) eine Teilstruktur M(L)ₙ der Formel (2) oder Formel (3) enthält: 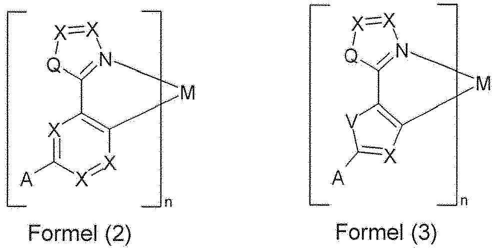 wobei A gleich oder verschieden bei jedem Auftreten eine Gruppe der folgenden Formel (A) darstellt: 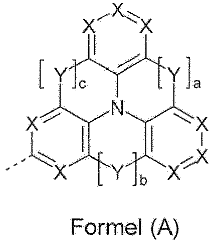 wobei die gestrichelte Bindung in Formel (A) die Position der Verknüpfung dieser Gruppe darstellt und für die weiteren verwendeten Symbole und Indizes gilt:
- M: ist ein Metall ausgewählt aus der Gruppe bestehend aus Iridium, Rhodium, Platin und Palladium;
- X: ist gleich oder verschieden bei jedem Auftreten CR¹ oder N;
- Q: ist gleich oder verschieden bei jedem Auftreten R¹C=CR¹, R¹C=N, O, S, Se oder NR¹;
- V: ist gleich oder verschieden bei jedem Auftreten O, S, Se oder NR¹;
- Y: ist gleich oder verschieden bei jedem Auftreten eine Einfachbindung oder eine bivalente Gruppe ausgewählt aus C(R¹)₂, C(=O), O, S, NR¹ oder BR¹;
- R¹: ist gleich oder verschieden bei jedem Auftreten H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination aus zwei oder mehr dieser Gruppen; dabei können zwei oder mehr Reste R¹ auch miteinander ein mono- oder polycyclisches, aliphatisches, aromatisches und/oder benzoannelliertes Ringsystem bilden;
- R²: ist gleich oder verschieden bei jedem Auftreten H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination aus zwei oder mehr dieser Gruppen; dabei können zwei oder mehrere benachbarte Reste R² miteinander ein mono- oder polycyclisches, aliphatisches, aromatisches und/oder benzoannelliertes Ringsystem bilden;
- R³: ist gleich oder verschieden bei jedem Auftreten H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches, aromatisches und/oder benzoannelliertes Ringsystem bilden;
- L': ist gleich oder verschieden bei jedem Auftreten ein Coligand;
- n: ist 1, 2 oder 3 für M gleich Iridium oder Rhodium und ist 1 oder 2 für M gleich Platin oder Palladium;
- m: ist 0, 1, 2, 3 oder 4;
- a, b, c: ist gleich oder verschieden bei jedem Auftreten 0 oder 1, wobei a = 0 bzw. b = 0 bzw. c = 0 bedeutet, dass die jeweilige Gruppe Y nicht vorhanden ist und statt dessen an die entsprechenden Kohlenstoffatome jeweils ein Rest R¹ gebunden ist; mit der Maßgabe, dass a + b + c ≥ 2 ist;
dabei können auch mehrere Liganden L miteinander oder L mit L' über eine beliebige Brücke Z verknüpft sein und so ein tridentates, tetradentates, pentadentates oder hexadentates Ligandensystem aufspannen.

Dabei werden die Indizes n und m so gewählt, dass die Koordinationszahl am Metall für M gleich Iridium oder Rhodium 6 entspricht und für M gleich Platin oder Palladium 4 entspricht.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, neo-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Wenn zwei benachbarte Reste R¹ bzw. R² miteinander ein Ringsystem bilden, so sind die gebildeten Ringsysteme aliphatische oder aromatische Ringe, die an den Liganden ankondensiert sind. Beispiele für derartige Ringsysteme sind ankondensierte Cyclohexylgruppen oder ankondensierte Phenylgruppen. Es ist dabei auch möglich, dass Reste, die an die beiden unterschiedlichen aromatischen Ringe des Liganden binden, also beispielsweise an die Phenylgruppe und die Pyridingruppe, miteinander einen Ring bilden, was beispielsweise zu Azafluorenstrukturen öder Benzo[h]-chinolinstrukturen führen kann. Weiterhin ist beispielsweise möglich, wenn Q für CR¹=CR¹ steht, dass diese Reste miteinander einen aromatischen Ring bilden, so dass insgesamt beispielsweise eine Isochinolinstruktur gebildet wird.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Liganden L und L' so gewählt werden, dass sie die Ladung des komplexierten Metallatoms M kompensieren.

Bevorzugt sind weiterhin Verbindungen gemäß Formel (1), dadurch gekennzeichnet, dass die Summe der Valenzelektronen um das Metallatom für Platin und Palladium 16 und für Iridium oder Rhodium 18 beträgt. Diese Bevorzugung ist durch die besondere Stabilität dieser Metallkomplexe begründet.

In einer bevorzugten Ausführungsform der Erfindung steht M für Iridium oder Platin. Besonders bevorzugt steht M für Iridium.

Wenn M für Platin oder Palladium steht, steht der Index n für 1 oder 2. Wenn der Index n = 1 ist, sind noch ein bidentater oder zwei monodentate Liganden L', bevorzugt ein bidentater Ligand L', an das Metall M koordiniert. Entsprechend ist für einen bidentaten Liganden L' der Index m = 1 und für zwei monodentate Liganden L' der Index m = 2. Wenn der Index n = 2 ist, ist der Index m = 0.

Wenn M für Iridium oder Rhodium steht, steht der Index n für 1, 2 oder 3, bevorzugt für 2 oder 3. Wenn der Index n = 1 ist, sind noch vier monodentate oder zwei bidentate oder ein bidentater und zwei monodentate oder ein tridentater und ein monodentater oder ein tetradentater Ligand L', bevorzugt zwei bidentate Liganden L', an das Metall koordiniert. Entsprechend ist der Index m, je nach Liganden L', gleich 1, 2, 3 oder 4. Wenn der Index n = 2 ist, sind noch ein bidentater oder zwei monodentate Liganden L', bevorzugt ein bidentater Ligand L', an das Metall koordiniert. Entsprechend ist der Index m, je nach Liganden L', gleich 1 oder 2. Wenn der Index n = 3 ist, ist der Index m = 0.

In einer bevorzugten Ausführungsform der Erfindung steht maximal ein Symbol X pro Cyclus für N und die anderen Symbole X stehen für CR¹. Besonders bevorzugt steht das Symbol X gleich oder verschieden bei jedem Auftreten für CR¹.

In einer weiteren bevorzugten Ausführungsform der Erfindung steht das Symbol Q gleich oder verschieden bei jedem Auftreten für R¹C=CR¹ oder R¹C=N, besonders bevorzugt für R¹C=CR¹.

In einer weiteren bevorzugten Ausführungsform der Erfindung steht das Symbol V gleich oder verschieden bei jedem Auftreten für O, S oder NR¹, besonders bevorzugt für S.

In einer weiteren bevorzugten Ausführungsform der Erfindung sind in der Gruppe der Formel (A) zwei der Indizes a, b und c = 1 und der dritte Index ist = 0. Geeignet sind hier die folgenden Kombinationen:
a = b = 1 und c = 0; oder
b = c = 1 und a = 0.
In einer besonders bevorzugten Ausführungsform der Erfindung ist
a = b = 1 und c = 0.

In einer weiteren bevorzugten Ausführungsform der Erfindung steht das Symbol Y gleich oder verschieden bei jedem Auftreten für eine Einfachbindung oder eine bivalente Gruppe ausgewählt aus C(R¹)₂, NR¹ oder O, wobei bevorzugt maximal eine der Gruppen Y für eine Einfachbindung steht.

Bevorzugte Gruppen A sind die Gruppen der folgenden Formeln (A-1), (A-2) und (A-3), 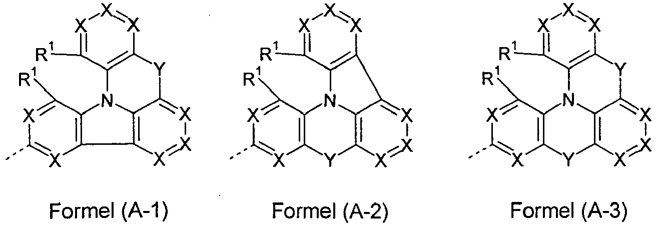 wobei Y für C(R¹)₂, NR¹, O oder S steht und die weiteren verwendeten Symbole die oben genannten Bedeutungen aufweisen.

Besonders bevorzugte Ausführungsformen der Gruppe A sind die Strukturen der folgenden Formeln (A-1a), (A-2a) und (A-3a), 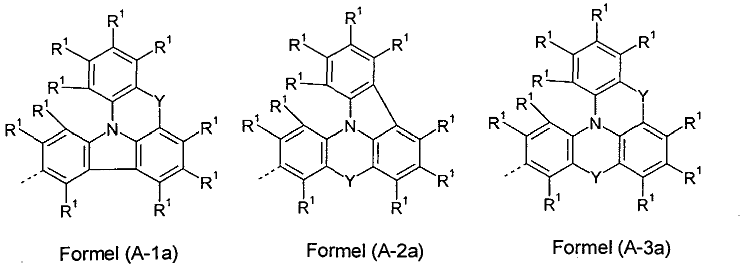 wobei Y für C(R¹)₂, NR¹ oder O steht und die weiteren verwendeten Symbole die oben genannten Bedeutungen aufweisen.

Ganz besonders bevorzugte Ausführungsformen der Gruppe A sind die Strukturen der folgenden Formeln (A-1b), (A-2b) und (A-3b), 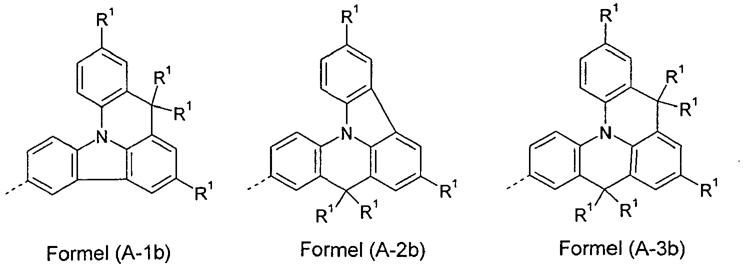 wobei die verwendeten Symbole die oben genannten Bedeutungen aufweisen.

Es ist besonders bevorzugt, wenn die oben genannten Bevorzugungen gleichzeitig gelten. In einer besonders bevorzugten Ausführungsform der Erfindung gilt daher für die verwendeten Symbole:
- M: ist Iridium oder Platin;
- A: ist gleich oder verschieden bei jedem Auftreten eine Gruppe der oben genannten Formel (A-1a) bzw. (A-2a) bzw. (A-3a);
- X: ist gleich oder verschieden bei jedem Auftreten CR¹;
- Q: ist gleich oder verschieden bei jedem Auftreten R¹C=CR¹ oder R¹C=N;
- V: ist gleich oder verschieden bei jedem Auftreten O, S oder NR¹;
- Y: ist gleich oder verschieden bei jedem Auftreten C(R¹)₂, NR¹ oder O.

In einer ganz besonders bevorzugten Ausführungsform der Erfindung gilt für die verwendeten Symbole:
- M: ist Iridium;
- A: ist gleich oder verschieden bei jedem Auftreten eine Gruppe der oben genannten (A-1b) bzw. (A-2b) bzw. (A-3b);
- X: ist gleich oder verschieden bei jedem Auftreten CR¹;
- Q: ist gleich oder verschieden bei jedem R¹C=CR¹;
- V: ist S;
- Y: ist gleich oder verschieden bei jedem Auftreten C(R¹)₂, NR¹ oder O.

In einer besonders bevorzugten Ausführungsform der Erfindung sind die Teilstrukturen der Formel (2) oder (3) daher ausgewählt aus den Teilstrukturen der folgenden Formeln (4) oder (5), 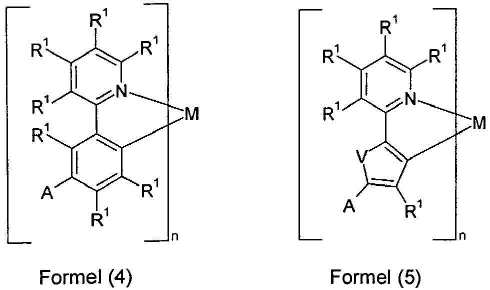 wobei die verwendeten Symbole und Indizes die oben genannten Bedeutungen aufweisen, insbesondere die oben genannten bevorzugten Bedeutungen.

Wie oben bereits erwähnt, können dabei auch benachbarte Reste R¹ einen Ring miteinander bilden. So sind beispielsweise aus den Pyridinringen Chinolin- oder Isochinolinstrukturen zugänglich, die mit einem oder mehreren Resten R² substituiert sein können, oder die beiden koordinierenden Cyclen sind miteinander verbrückt.

Bevorzugte Strukturen, die dadurch entstehen, dass benachbarte Reste R¹ miteinander einen Ring bilden, sind die Strukturen der folgenden Formeln (4-1), (4-2), (4-3), (4-4), (5-1), (5-2) und (5-3), 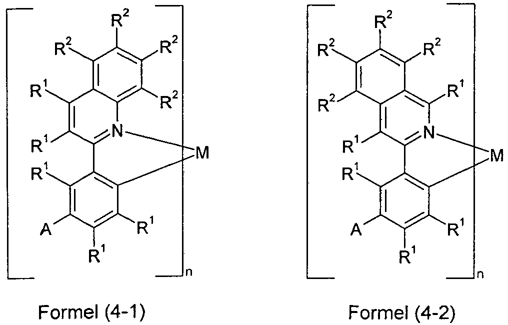 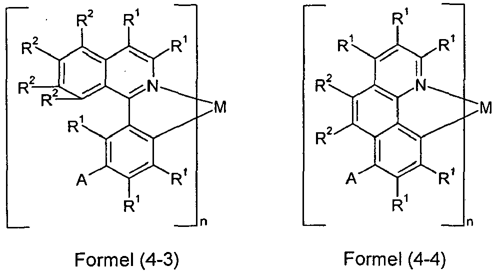 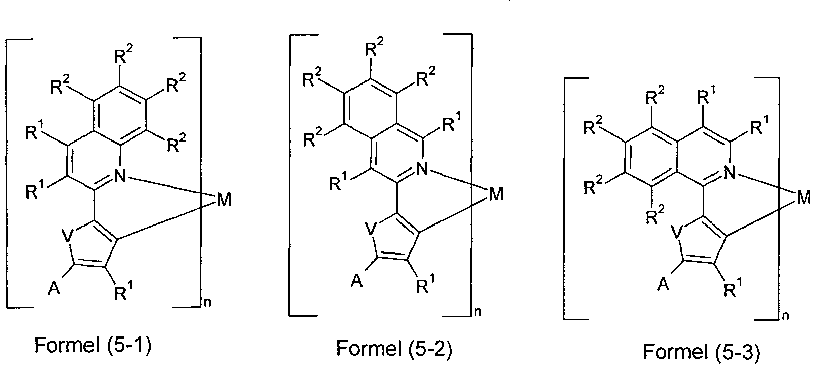 wobei die verwendeten Symbole und Indizes die oben genannten Bedeutungen aufweisen.

Dabei ist in den Strukturen gemäß Formel (4) bzw. (4-1) bis (4-4) und (5) bzw. (5-1) bis (5-3) die Gruppe A bevorzugt ausgewählt aus den Strukturen der Formeln (A-1a) bzw. (A-2a) bzw. (A-3a) und besonders bevorzugt aus den Strukturen der Formeln (A-1b) bzw. (A-2b) bzw. (A-3b).

Es kann bevorzugt sein, wenn einer der Reste R¹, entweder in den Verbindungen der Formel (4), (4-1) bis (4-4), (5) und (5-1) bis (5-3) oder in den Gruppen A der Formel (A), für eine Styrylgruppe bzw. für eine endständige Alkenylgruppe steht. Derartige Gruppen eignen sich für die Vernetzung der erfindungsgemäßen Verbindungen in der Schicht. Eine solche Vernetzung kann sinnvoll sein, um Mehrschichtdevices aus Lösung herstellen zu können.

Wie oben beschrieben, kann auch statt einem der Reste R¹ eine verbrückende Einheit Z vorhanden sein, die diesen Liganden L mit einem oder mehreren weiteren Liganden L bzw. L' verknüpft. In einer bevorzugten Ausführungsform der Erfindung ist statt einem der Reste R¹ eine verbrückende Einheit Z vorhanden, so dass die Liganden dreizähnigen oder mehrzähnigen oder polypodalen Charakter aufweisen. Es können auch zwei solcher verbrückenden Einheiten Z vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (6) bis (9), 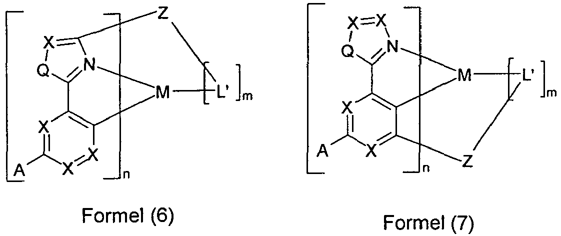 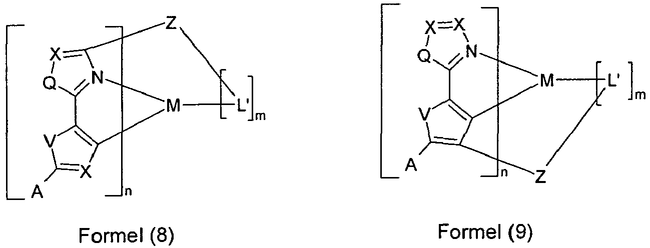 wobei die verwendeten Symbole die oben genannten Bedeutungen aufweisen und Z bevorzugt eine verbrückende Einheit darstellt, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von Z zu L bzw. L' muss nicht identisch sein. Die verbrückende Einheit Z kann neutral, einfach, zweifach oder dreifach negativ oder einfach, zweifach oder dreifach positiv geladen sein. Bevorzugt ist Z neutral oder einfach negativ oder einfach positiv geladen. Dabei wird die Ladung von Z bevorzugt so gewählt, dass insgesamt ein neutraler Komplex entsteht.

Die genaue Struktur und chemische Zusammensetzung der Gruppe Z hat keinen wesentlichen Einfluss auf die elektronischen Eigenschaften des Komplexes, da die Aufgabe dieser Gruppe im Wesentlichen ist, durch die Verbrückung von L miteinander bzw. mit L' die chemische und thermische Stabilität der Komplexe zu erhöhen.

Wenn Z eine trivalente Gruppe ist, also drei Liganden L miteinander bzw. zwei Liganden L mit L' oder einen Liganden L mit zwei Liganden L' verbrückt, ist Z bevorzugt gleich oder verschieden bei jedem Auftreten gewählt aus der Gruppe bestehend aus B, B(R²)⁻, B(C(R²)₂)₃, (R²)B(C(R²)₂)₃⁻, B(O)₃, (R²)B(O)₃⁻, B(C(R²)₂C(R²)₂)₃, (R²)B(C(R²)₂C(R²)₂)₃-, B(C(R²)₂O)₃, (R²)B(C(R²)₂O)₃⁻, B(OC(R²)₂)₃, (R²)B(OC(R²)₂)₃⁻, C(R²), CO⁻, CN(R²)₂, (R²)C(C(R²)₂)₃, (R²)C(O)₃, (R²)C(C(R²)₂C(R²)₂)₃, (R²)C(C(R²)₂O)₃, (R²)C(OC(R²)₂)₃, (R²)C(Si(R²)₂)₃, (R²)C(Si(R²)₂C(R²)₂)₃, (R²)C(C(R²)₂Si(R²)₂)₃, Si(R²), (R²)Si(C(R²)₂)₃, (R²)Si(O)₃, (R²)Si(C(R²)₂C(R²)₂)₃, (R²)Si(OC(R²)₂)₃, (R²)Si(C(R²)₂O)₃, N, NO, N(R²)⁺, N(C(R²)₂)₃, (R²)N(C(R²)₂)₃⁺, N(C=O)₃, N(C(R²)₂C(R²)₂)₃, (R²)N(C(R²)₂C(R²)₂)⁺, P, PO, P(O)₃, PO(O)₃, P(OC(R²)₂)₃, PO(OC(R²)₂)₃, P(C(R²)₂)₃, P(R²)(C(R²)₂)₃⁺, PO(C(R²)₂)₃, P(C(R²)₂C(R²)₂)₃, PO(C(R²)₂C(R²)₂)₃, oder eine Einheit gemäß Formel (10), (11), (12) oder (13), 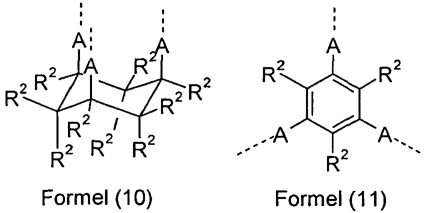 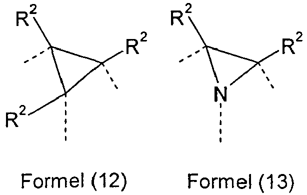 wobei die gestrichelten Bindungen jeweils die Bindung zu den Teilliganden L bzw. L' andeuten und A gleich oder verschieden bei jedem Auftreten ausgewählt ist aus der Gruppe bestehend aus einer Einfachbindung, O, S, S(=O), S(=O)₂, NR², PR², P(=O)R², P(=NR²), C(R²)₂, C(=O), C(=NR²), C(=C(R²)₂), Si(R²)₂ oder BR². Die weiteren verwendeten Symbole haben die oben genannten Bedeutungen.

Wenn Z eine bivalente Gruppe ist, also zwei Liganden L miteinander bzw. einen Liganden L mit L' verbrückt, ist Z bevorzugt gleich oder verschieden bei jedem Auftreten gewählt aus der Gruppe bestehend aus BR², C(R²)₂, C(=O), Si(R²)₂, NR², PR², P(=O)(R²), O, S oder eine Einheit gemäß Formel (14) bis (22), 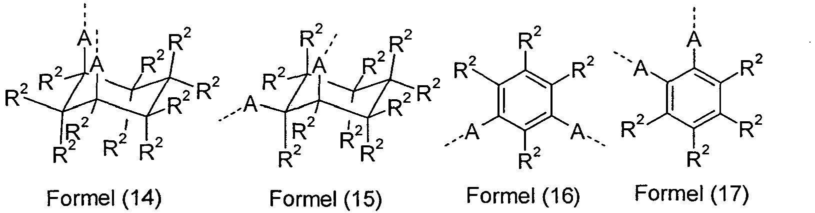 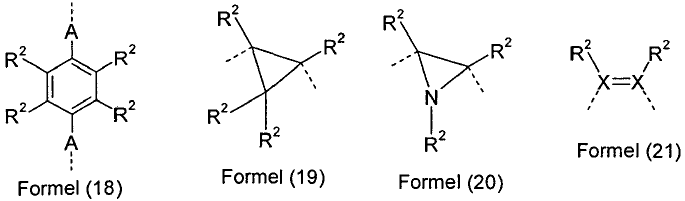 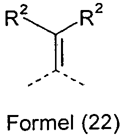 wobei die gestrichelten Bindungen jeweils die Bindung zu den Teilliganden L bzw. L' andeuten und die weiteren verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit Z an L gebunden sind.

Die Liganden L' sind bevorzugt neutrale, monoanionische, dianionische oder trianionische Liganden, besonders bevorzugt neutrale oder monoanionische Liganden. Sie können monodentat, bidentat, tridentat oder tetradentat sein und sind bevorzugt bidentat, weisen also bevorzugt zwei Koordinationsstellen auf. Wie oben beschrieben, können die Liganden L' auch über eine verbrückende Gruppe Z an L gebunden sein.

Bevorzugte neutrale, monodentate Liganden L' sind ausgewählt aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L' sind ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso-*propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind O²⁻, S²⁻, Carbide, welche zu einer Koordination der Form R-C≡M führen, und Nitrene, welche zu einer Koordination der Form R-N=M führen, wobei R allgemein für einen Substituenten steht, oder N³⁻.

Bevorzugte neutrale oder mono- oder dianionische, bidentate oder höherdentate Liganden L' sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[(1-(Phenylimino)ethyl]pyridin, 2-[(1-(2-Methylphenylimino)ethyl]pyridin, 2-[(1-(2,6-Di-*iso*-propylphenylimino)ethyl]pyridin, 2-[(1-(Methylimino)ethyl]pyridin, 2-[(1-(ethylimino)ethyl]pyridin, 2-[(1-(*Iso*-Propylimino)ethyl]pyridin, 2-[(1-(*Tert*-Butylimino)ethyl]pyridin, Diminen, wie z. B. 1,2-Bis(methylimino)-ethan, 1,2-Bis(ethylimino)ethan, 1,2-Bis(*iso*-propylimino)ethan, 1,2-Bis(*tert-*butylimino)ethan, 2,3-Bis(methylimino)butan, 2,3-Bis(ethylimino)butan, 2,3-Bis(*iso*-propylimino)butan, 2,3-Bis(*tert*-butylimino)butan, 1,2-Bis-(phenylimino)ethan, 1,2-Bis(2-methylphenylimino)ethan, 1,2-Bis(2,6-di-*iso-*propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis-(2,6-di-*iso*-propylphenylimino)butan, 2,3-Bis(2,6-di-*tert*-butylphenylimino)-butan, Heterocyclen enthaltend zwei Stickstoffatome, wie z. B. 2,2'-Bipyridin, o-Phenanthrolin, Diphosphinen, wie z. B. Bis-diphenylphosphinomethan, Bis-diphenylphosphinoethan, Bis(diphenylphosphino)propan, Bis(diphenylphosphino)butan, Bis(dimethylphosphino)methan, Bis(di-methylphosphino)ethan, Bis(dimethylphosphino)propan, Bis(diethylphosphino)methan, Bis(diethylphosphino)ethan, Bis(diethylphosphino)-propan, Bis(di-*tert*-butylphosphino)methan, Bis(di-*tert*-butylphosphino)-ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden sind Borate stickstoffhaltiger Heterocyclen, wie z. B. Tetrakis(1-imidazolyl)borat und Tetrakis(1-pyrazolyl)borat.

Besonders bevorzugt sind weiterhin bidentate monoanionische Liganden L', welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R¹ substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (23) bis (50) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand L' kann dann aus den Gruppen der Formeln (23) bis (50) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten Z an den Liganden L gebunden sein.

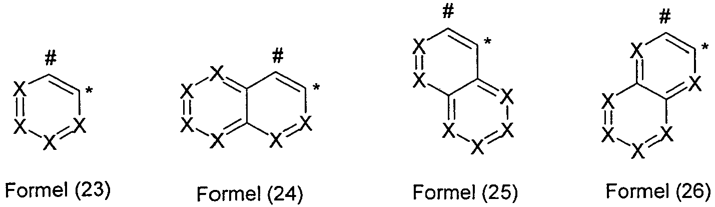

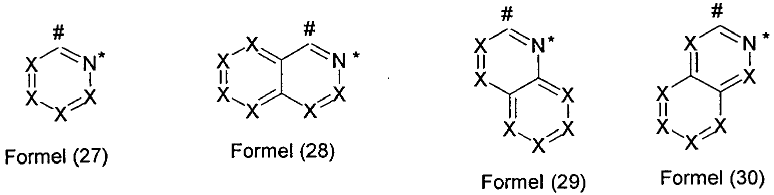

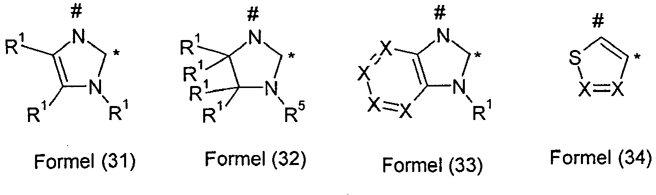

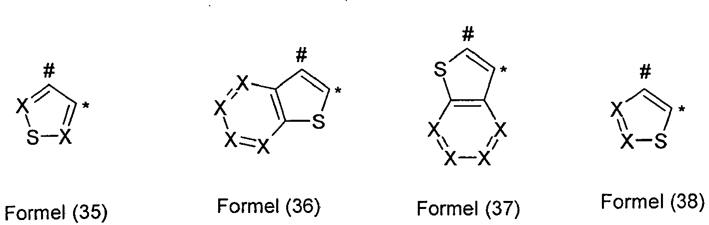

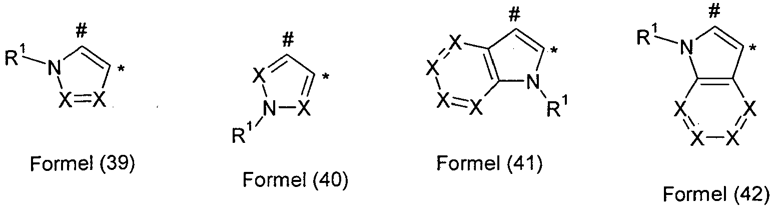

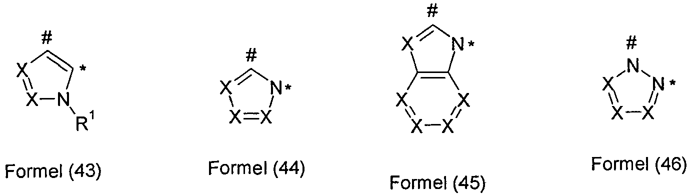

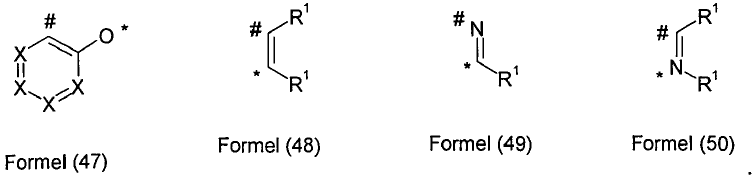

Dabei haben die verwendeten Symbole dieselbe Bedeutung wie oben beschrieben, und bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X gleich oder verschieden bei jedem Auftreten für CR¹. Weiterhin können die Gruppen gemäß Formel (34) bis (38) auch O statt S enthalten.

Ebenfalls bevorzugte Liganden L' sind η⁵-Cyclopentadienyl, η⁵-Pentamethylcyclopentadienyl, η⁶-Benzol oder η⁷-Cycloheptatrienyl, welche jeweils durch einen oder mehrere Reste R¹ substituiert sein können.

Ebenfalls bevorzugte Liganden L' sind 1,3,5-cis-Cyclohexanderivate, insbesondere der Formel (51), 1,1,1-Tri(methylen)methanderivate, insbesondere der Formel (52) und 1,1,1-trisubstituierte Methane, insbesondere der Formel (53) und (54), 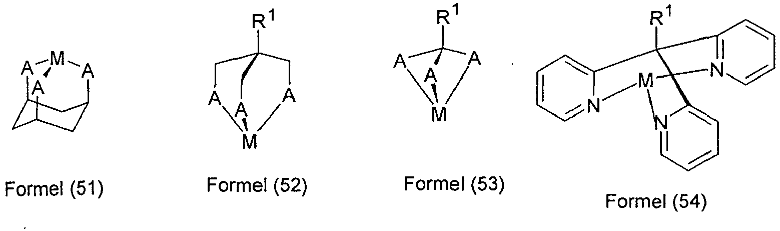 wobei in den Formeln jeweils die Koordination an das Metall M dargestellt ist, R¹ die oben genannte Bedeutung hat und A, gleich oder verschieden bei jedem Auftreten, für O⁻, S⁻, COO⁻, P(R¹)₂ oder N(R¹)₂ steht.

Bevorzugte Reste R¹ in den oben aufgeführten Strukturen sowie in den oben genannten bevorzugten Ausführungsformen sind bei jedem Auftreten gleich oder verschieden ausgewählt aus der Gruppe bestehend aus H, D, F, Br, N(R²)₂, CN, B(OR²)₂, C(=O)R², P(=O)(R²)₂, einer geradkettigen Alkylgruppe mit 1 bis 10 C-Atomen oder einer geradkettigen Alkenyl- oder Alkinylgruppe mit 2 bis 10 C-Atomen oder einer verzweigten oder cyclischen Alkyl-, Alkenyl- oder Alkinylgruppe mit 3 bis 10 C-Atomen, die jeweils mit einem oder mehreren Resten R² substituiert sein kann, wobei ein oder mehrere H-Atome durch F ersetzt sein können, oder einem aromatischen oder heteroaromatischen Ringsystem mit 5 bis 14 aromatischen Ringatomen, das jeweils durch einen oder mehrere Reste R² substituiert sein kann; dabei können mehrere Reste R¹ auch miteinander ein mono- oder polycyclisches, aliphatisches, aromatisches und/oder benzoannelliertes Ringsystem bilden. Besonders bevorzugte Reste R¹ sind bei jedem Auftreten gleich oder verschieden ausgewählt aus der Gruppe bestehend aus H, F, Br, CN, B(OR²)₂, einer geradkettigen Alkylgruppe mit 1 bis 6 C-Atomen, insbesondere Methyl, oder einer verzweigten oder cyclischen Alkylgruppe mit 3 bis 10 C-Atomen, insbesondere iso-Propyl oder tert-Butyl, wobei ein oder mehrere H-Atome durch F ersetzt sein können, oder ein aromatisches oder heteroaromatisches Ringsystem mit 5 bis 12 aromatischen Ringatomen, das jeweils durch einen oder mehrere Reste R² substituiert sein kann; dabei können mehrere Reste R¹ auch miteinander ein mono- oder polycyclisches, aliphatisches, aromatisches und/oder benzoannelliertes Ringsystem bilden.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) durch Umsetzung der entsprechenden freien Liganden mit Metallalkoholaten der Formel (55), mit Metallketoketonaten der Formel (56), mit Metallhalogeniden der Formel (57) oder mit dimeren Metallkomplexen der Formel (58), 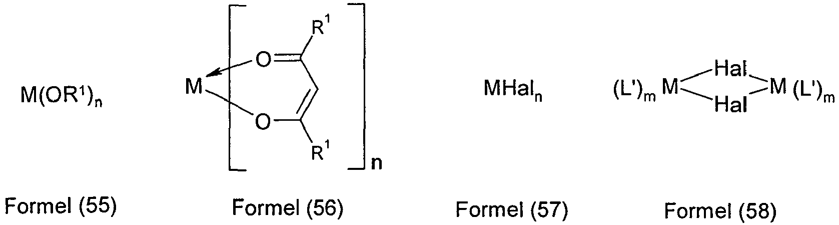 wobei die Symbole M, m, n und R¹ die oben angegebenen Bedeutungen haben und HaI = F, Cl, Br oder I ist.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet ist [IrCl₂(acac)₂]⁻, beispielsweise Na[IrCl₂(acac)₂].

Die Synthese heteroleptischer Komplexe geht bevorzugt von dem chloroverbrückten Dimer aus, also für Iridiumkomplexe von [(L)₂IrCl]₂ bzw. [(L')₂IrCl]₂. Dabei kann es bevorzugt sein, dieses mit dem Liganden L' bzw. L unter Einsatz einer Lewis-Säure, eines Silbersalzes und/oder einer Säure umzusetzen. Als besonders geeignet hat sich die Umsetzung mit Trifluorsulfonsäure erwiesen, gefolgt von der Umsetzung mit dem Liganden L' bzw. L.

Die Synthese der Komplexe wird bevorzugt durchgeführt wie in WO 2002/060910 und in WO 2004/085449 beschrieben. Heteroleptische Komplexe können beispielsweise auch gemäß WO 2005/042548 synthetisiert werden. Dabei kann die Synthese beispielsweise auch thermisch, photochemisch, durch Mikrowellenstrahlung und/oder im Autoklaven aktiviert werden.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethyleneglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, insbesondere eine Lösung oder Dispersion, enthaltend mindestens eine Verbindung gemäß Formel (1) oder gemäß den oben aufgeführten bevorzugten Ausführungsformen und mindestens eine weitere Verbindung, insbesondere ein Lösemittel. Dabei kann die Formulierung außer der Verbindung gemäß Formel (1) und dem oder den Lösemitteln auch noch weitere Verbindungen enthalten, wie beispielsweise ein oder mehrere Matrixmaterialien.

Die oben beschriebenen Komplexe gemäß Formel (1) bzw. die oben aufgeführten bevorzugten Ausführungsformen können in einer elektronischen Vorrichtung als aktive Komponente verwendet werden. Ein weiterer Gegenstand der vorliegenden Erfindung ist daher die Verwendung einer Verbindung nach Formel (1) bzw. nach einer der bevorzugten Ausführungsformen in einer elektronischen Vorrichtung. Weiterhin können die erfindungsgemäßen Verbindungen zur Erzeugung von Singulett-Sauerstoff, in der Photokatalyse oder in Sauerstoffsensoren eingesetzt werden.

Nochmals ein weiterer Gegenstand der vorliegenden Erfindung ist eine elektronische Vorrichtung enthaltend mindestens eine Verbindung gemäß Formel (1) bzw. gemäß den bevorzugten Ausführungsformen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Dreischichtsysteme, wobei die drei Schichten blaue, grüne und orange oder rote Emission zeigen (siehe z. B. WO 2005/011013) bzw. Systeme, welche mehr als drei emittierende Schichten aufweisen. Eine weitere bevorzugte Ausführungsform sind Zweischichtsysteme, wobei die beiden Schichten entweder blaue und gelbe oder blaugrüne und orange Emission zeigen. Zweischichtsysteme sind insbesondere für Beleuchtungsanwendungen von Interesse. Solche Ausführungsformen sind mit den erfindungsgemäßen Verbindungen besonders geeignet, da diese häufig gelbe bzw. orange Emission zeigen. Die weiß emittierenden Elektrolumineszenzvorrichtungen können für Beleuchtungsanwendungen oder als Backlight für Displays oder mit Farbfilter als Display eingesetzt werden.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bzw. der Matrixmaterialien bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Berylliumkomplexe, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen. Hierfür eignen sich insbesondere Mischungen aus mindestens einem elektronentransportierenden Matrixmaterial und mindestens einem lochtransportierenden Matrixmaterial oder Mischungen aus mindestens zwei elektronentransportierenden Matrixmaterialien oder Mischungen aus mindestens einem loch- oder elektronentransportierenden Matrixmaterial und mindestens einem weiteren Material mit einer großen Bandlücke, welches somit weitgehend elektrisch inert ist und nicht oder nicht in wesentlichem Umfang am Ladungstransport teilnimmt, wie z. B. in WO 2010/108579 beschrieben. Eine bevorzugte Kombination ist beispielsweise die Verwendung eines aromatischen Ketons oder eines Triazinderivats mit einem Triarylamin-Derivat oder einem Carbazol-Derivat als gemischte Matrix für den erfindungsgemäßen Metallkomplex.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise blau oder grün emittierende Triplettemitter als Co-Matrix für die erfindungsgemäßen Komplexe gemäß Formel (1) eingesetzt werden.

Die erfindungsgemäßen Verbindungen sind insbesondere auch geeignet als phosphoreszierende Emitter in organischen Elektrolumineszenzvorrichtungen, wie sie z. B. in WO 98/24271, US 2011/0248247 und US 2012/0223633 beschrieben sind. In diesen mehrfarbigen Display-Bauteilen wird eine zusätzliche blaue Emissionsschicht vollflächig auf alle Pixel, auch diejenigen mit einer von Blau verschiedenen Farbe, aufgedampft. Dabei wurde gefunden, dass die erfindungsgemäßen Verbindungen, wenn sie als Emitter für das rote und/oder grüne Pixel eingesetzt werden, zusammen mit der aufgedampften blauen Emissionsschicht zu sehr guter Emission führen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, AI, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten können generell alle Materialien verwendet werden, wie sie gemäß dem Stand der Technik für die Schichten verwendet werden und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Die Verbindungen gemäß Formel (1) weisen eine gute Löslichkeit in einer Vielzahl gängiger organischer Lösemittel auf und sind daher sehr gut für die Verarbeitung aus Lösung geeignet.
2. Die Verbindungen weisen eine hohe Photolumineszenzquanteneffizienz auf.
3. Die Verbindungen weisen ein schmaleres Emissionsspektrum auf als Verbindungen, die mit ähnlichen Carbazolderivaten gemäß dem Stand der Technik substituiert sind. Dies resultiert in einer größeren Farbreinheit.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und die Erfindung somit im gesamten offenbarten Bereich ausführen.

### Beispiele:

Alle Synthesen werden unter einer Schutzgasatmosphäre in getrockneten Lösungsmitteln durchgeführt, wenn nichts anderes angegeben ist. Die Angaben in eckigen Klammern beziehen sich auf die CAS-Nummern der literaturbekannten Verbindungen.

### A) Herstellung von Vorstufen: Homoleptische bromierte Iridium-Komplexe

### A.1) Ir(L1Br)₃ / Tris-[1-(3-Bromphenyl)isochinolinato]iridium(III)

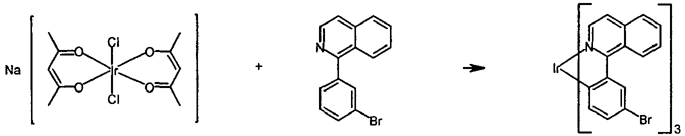

Ein Gemisch von 4.84 g (10.0 mmol) Natriumbis(acetylacetonato)dichloro-iridat(III) [770720-50-8] und 14.45 g (50.9 mmol) 1-(3-Bromphenyl)isochinolin [936498-09-8] wird in 200 ml Ethylenglykol für 48 h unter Rückfluss erhitzt. Nach Erkalten wird der gebildete Niederschlag über eine Glasfilterfritte abgetrennt, dreimal mit je 50 ml Wasser und dreimal mit je 50 ml Methanol gewaschen. Das Rohprodukt wird zweimal aus etwa 200 ml DMSO umkristallisiert, dreimal mit je etwa 50 ml Methanol gewaschen und im Vakuum getrocknet. Es verbleiben 7.50 g (7.20 mmol, 72% der Theorie) Ir(L1Br)₃ als roter Feststoff.

In analoger Weise können die Vorstufen Ir(L2Br)₃ und Ir(L3)₃ aus Na[Ir(acac)₂Cl₂] und dem entsprechenden Liganden L hergestellt werden:

| **Bsp.** | **Ligand L [CAS]** | **Produkt** | **Ausbeute** |
|---|---|---|---|
| Ir(L2Br)₃ | 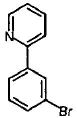 | 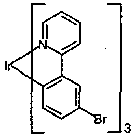 | 78% |
| | L2Br [4373-60-8] | | |
| Ir(L3)₃ | 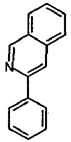 | 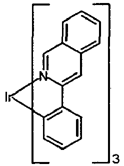 | 61% |
| | L3 [37993-76-3] | | |

### A.2) Ir(L4)₃ / Tris-(6-tert-butyl-9,10-dimethylbenzo[4,5]imidazo[1,2-c]-chinazolinato)iridium(III)

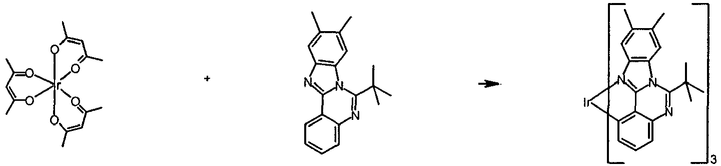

Tris-(6-tert-butyl-9,10-dimethylbenzo[4,5]imidazo[1,2-c]chinazolinato)-iridium(III) kann wie in der Anmeldung WO 2011/157339 beschrieben hergestellt werden: Ein Gemisch aus 4.90 g (10.1 mmol) Tris(acetyl-acetonato)iridium(III) [15635-87-7] und 18.20 g (60.0 mmol) 6-tert-Butyl-9,10-dimethylbenzo[4,5]imidazo[1,2-c]chinazolin [1352330-29-0] wird mit einem glasummantelten Magnetrührkern in einer dickwandigen 50 ml Glasampulle unter Vakuum (Druck ca. 10⁻⁵ mbar) abgeschmolzen. Die Ampulle wird für 100 h bei 270 °C unter Rühren getempert. Nach Erkalten wird die Ampulle geöffnet (ACHTUNG: Die Ampullen stehen meist unter Druck). Der Sinterkuchen wird mit 100 g Glaskugeln (Durchmesser 3 mm) in 100 ml Dichlormethan 3 h gerührt und dabei mechanisch aufgeschlossen. Die feine Suspension wird von den Glaskugeln abdekantiert, der Feststoff über eine Glasfilterfritte abgesaugt und im Vakuum getrocknet. Das getrocknete Rohprodukt wird in einem Heißextraktor über Aluminiumoxid (basisch, Aktivitätsstufe 1) mit etwa 500 ml THF extrahiert. Das Lösungsmittel wird im Vakuum auf etwa 100 ml eingeengt und der Metallkomplex durch langsames Zutropfen von etwa 200 ml Methanol ausgefällt. Der Feststoff wird abgesaugt und im Vakuum getrocknet. Es verbleiben 5.72 g (5.20 mmol, 52% der Theorie) als gelbes Pulver.

### A.3) Ir(L3Br)₃ / Tris-[3-(3-bromphenyl)isochinolinato]iridium(III)

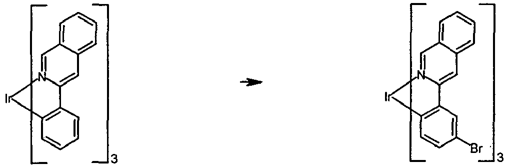

5.88 g (33.0 mmol) *N*-Bromsuccinimid werden unter Eiskühlung so zu einer Mischung von 8.04 g (10.0 mmol) Ir(L3)₃ in 150 ml THF gegeben, dass die Temperatur 5 °C nicht übersteigt. Es wird für 1 h bei 0 °C gerührt, dann wird die Kühlung entfernt und für 24 h nachgerührt. Das Lösungsmittel wird im Vakuum entfernt und der verbleibende Rückstand dreimal bei 60 °C mit je 50 ml Ethanol ausgerührt. Es verbleiben 9.72 g (9.33 mmol, 93% der Theorie) Ir(L3Br)₃ als roter Feststoff.

In analoger Weise kann Ir(L4Br)₃ durch Bromierung von Ir(L4)₃ hergestellt werden:

| **Bsp.** | **Edukt** | **Produkt** | **Ausbeute** |
|---|---|---|---|
| Ir(L4Br)₃ | 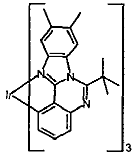 | 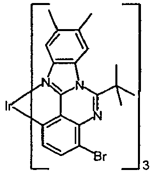 | 87% |
| | Ir(L4)₃ | | |

### B) Herstellung von Vorstufen: Chloro-Dimere

Dimere chlorverbrückte Iridiumkomplexe können in Analogie zu S. Sprouse, K. A. King, P. J. Spellane, R. J. Watts, J. Am. Chem. Soc. 106, 6647-6653 (1984) dargestellt werden:

### [Ir(L1Br)₂Cl]₂ / Tetrakis-(1-(3-bromphenyl)isochinolinato)(µ-dichlor)diiridium(III)

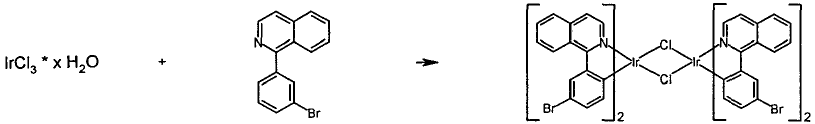

3.53 g (10.0 mmol) Iridiumtrichlorid-Hydrat [14996-61-3] werden mit 6.29 g (22.1 mmol) 1-(3-Bromphenyl)isochinolin [936498-09-8] in einem Gemisch aus 300 ml Ethoxyethanol und 100 ml Wasser für 24 h zum Rückfluss erhitzt. Nach Abkühlen auf Raumtemperatur wird der gebildete Feststoff über eine Glasfilterfritte abgetrennt und dreimal mit je 50 ml Ethanol gewaschen. Es verbleiben 10.06 g (6.34 mmol, 63% der Theorie) als roter Feststoff.

In analoger Weise können die Vorstufen [Ir(L2Br)₂Cl]₂ und [Ir(L5Br)₂Cl]₂ aus Iridiumtrichlorid-Hydrat und dem entsprechenden Liganden L hergestellt werden:

| **Bsp.** | **Ligand L [CAS]** | **Produkt** | **Ausbeute** |
|---|---|---|---|
| [Ir(L2Br)₂Cl]₂ | 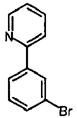 | 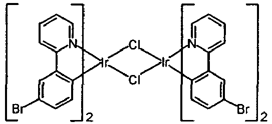 | 68% |
| | L2Br [4373-60-8] | | |
| [Ir(L5Br)₂]Cl₂ | 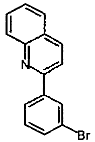 | 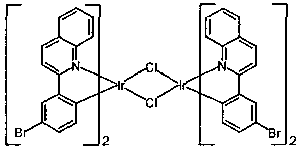 | 55% |
| | L5Br [108062-54-0] | | |

### C) Herstellung von Vorstufen: Boronsäureester

### BS1 / 8,8-Dimethyl-3-phenyl-6-(4,4,5,5-tetramethyl-[1,3,2]dioxa-borolan-2-yl)-8H-indolo[3,2,1-de]acridin

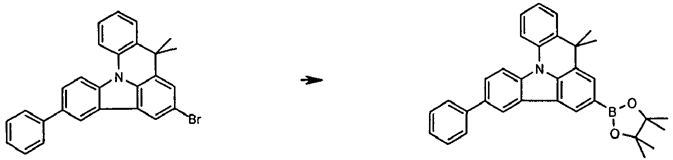

19.7 g (45 mmol) 6-Brom-8,8-dimethyl-3-phenyl-8H-indolo[3,2,1-de]acridin [1342816-23-2] werden in 350 ml THF vorgelegt und mit 9.8 g (100 mmol) Kaliumacetat, 24.1 g (95 mmol) Bis(pinacolato)diboran und 920 mg (1.1 mmol) 1,1'-Bis(diphenylphosphinoferrocen)palladium(II)chlorid-Dichlormethan-Komplex versetzt. Das Gemisch wird für 18 h zum Rückfluss erhitzt. Nach Erkalten wird mit 300 ml Essigester und 300 ml Wasser versetzt. Die organische Phase wird abgetrennt, dreimal mit je 150 ml Wasser gewaschen und über Magnesiumsulfat getrocknet. Das Lösungsmittel wird im Vakuum entfernt. Der Rückstand wird mit 150 ml Toluol in einem Heißextraktor über etwa 25 g Aluminiumoxid (basisch, Aktivitätsstufe 1) extrahiert. Nach Erkalten wird im Vakuum auf etwa 50 ml eingeengt und langsam mit 150 ml Ethanol versetzt. Der gebildete Feststoff wird abgesaugt und im Vakuum getrocknet. Es verbleiben 17.4 g (36 mmol, 80% der Theorie) als gelber Feststoff.

In analoger Weise können die Boronsäureester BS2 bis BS9 hergestellt werden:

| **Bsp.** | **Bromid [CAS]** | **Produkt** | **Ausbeute** |
|---|---|---|---|
| BS2 | 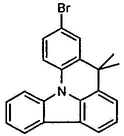 | 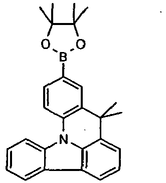 | 77% |
| | [1224892-55-0] | | |
| BS3 | 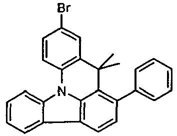 | 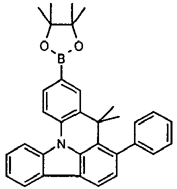 | 89% |
| | [1313415-77-8] | | |
| BS4 | 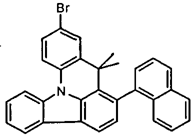 | 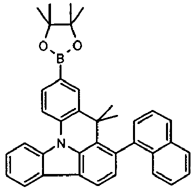 | 72% |
| | [1313415-80-3] | | |
| BS5 | 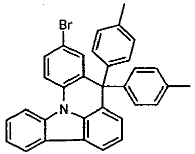 | 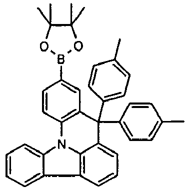 | 76% |
| | [1198843-16-1] | | |
| BS6 | 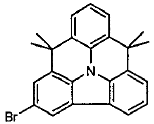 | 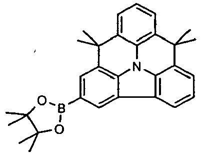 | 63% |
| | [1224892-58-3] | | |
| BS7 | 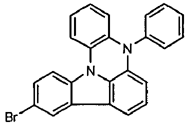 | 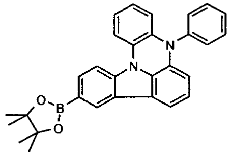 | 81% |
| | [1319016-10-8] | | |
| BS8 | 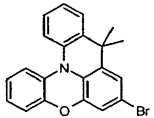 | 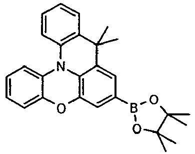 | 60% |
| | [1333316-16-7] | | |
| BS9 | 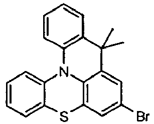 | 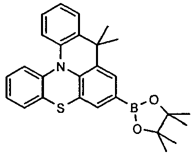 | 39% |
| | [1333316-15-6] | | |

### D) Herstellung von Vorstufen: Liganden

### L6 / 1-(Isochinolin-1-yl)-3-(8,8-dimethyl-8H-indolo[3,2,1-de]acridin-3-yl)-phenyl

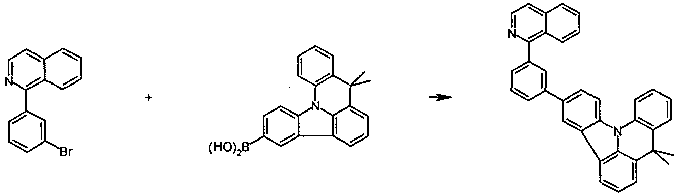

29.8 g (10.5 mmol) 1-(3-Bromphenyl)isochinolin [936498-09-8] werden mit 4.5 g (13.8 mmol) 8,8-Dimethyl-8H-indolo[3,2,1-de]acridin-3-yl-boronsäure [1307793-50-5], 4.4 g (31.8 mmol) Kaliumcarbonat und 0.3 g (0.25 mmol) Tetrakis(triphenylphosphin)palladium(0) in einem Gemisch aus 150 ml Toluol und 100 ml Wasser vorgelegt und unter kräftigem Rühren für 5 h zum Rückfluss erhitzt. Nach Abkühlen auf Raumtemperatur werden die Phasen getrennt. Die organische Phase wird dreimal mit je 100 ml Wasser gewaschen, über Magnesiumsulfat getrocknet und im Vakuum bis zur Trockene eingeengt. Der Rückstand wird im Hochvakuum (Druck ca. 10⁻⁶ mbar) bei 300 °C sublimiert. Es verbleiben 37.5 g (7.7 mmol, 73% der Theorie) des nach ¹H-NMR sauberen Produktes als hellbraunes Pulver.

In analoger Weise können die Liganden L7 bis L16 hergestellt werden:

| **Bsp.** | **Bromid** | **Boronsäure(ester) [CAS] bzw. Bsp.** | **Produkt** | **Ausbeute** |
|---|---|---|---|---|
| L7 | 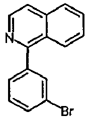 | 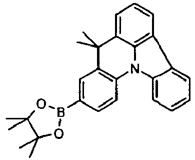 | 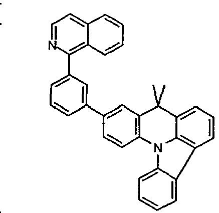 | 81% |
| | [936498-09-8] | BS2 | | |
| L8 | 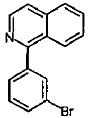 | 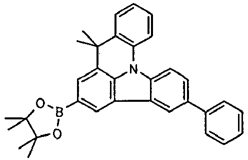 | 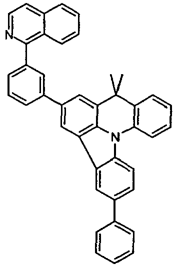 | 75% |
| | [936498-09-8] | BS1 | | |
| L9 | 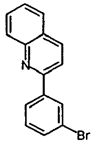 | 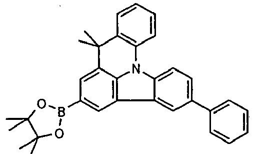 | 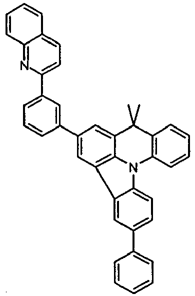 | 65% |
| | [108062-54-0] | BS1 | | |
| L10 | 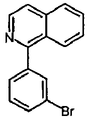 | 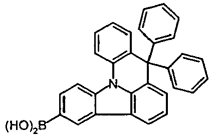 | 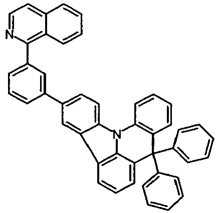 | 68% |
| | [936498-09-8] | [1290058-09-1] | | |
| L11 | 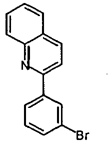 | 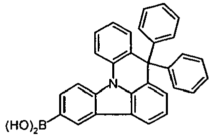 | 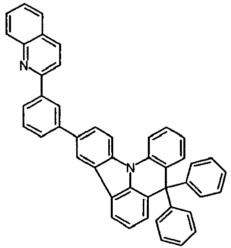 | 47% |
| | [108062-54-0] | [1290058-09-1] | | |
| L12 | 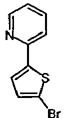 | 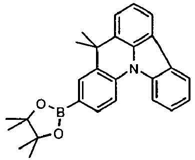 | 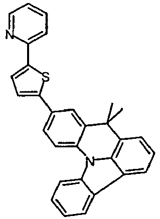 | 63% |
| | [123784-07-6] | BS2 | | |
| L13 | 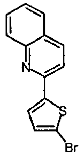 | 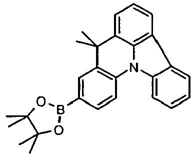 | 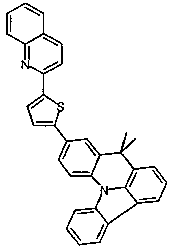 | 60% |
| | [81216-93-5] | BS2 | | |
| L14 | 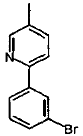 | 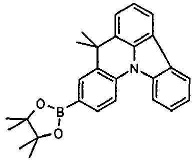 | 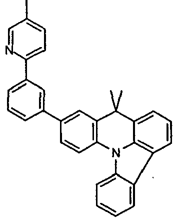 | 77% |
| | [872856-43-4] | BS2 | | |
| L15 | 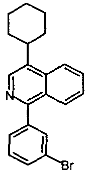 | 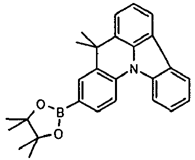 | 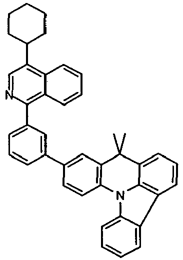 | 67% |
| | [1010100-81-8] | BS2 | | |
| L16 | 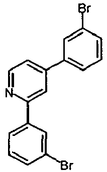 | 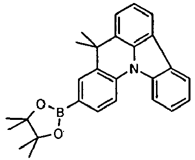 | 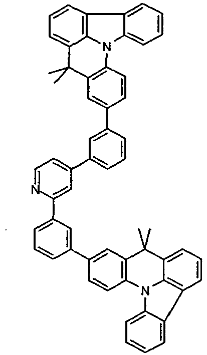 | 42% |
| | [1285694-88-3] | BS2 2.8 eq | | |

### E) Herstellung von Vorstufen: Heteroleptische bromierte Iridium-Komplexe

### E.1) Ir(L1Br)₂(CL1) / Bis-[1-(3-bromphenyl)isochinolinato]iridium(III)-acetylacetonat

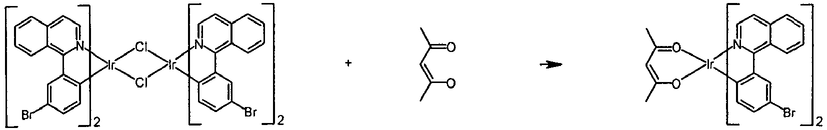

9.96 g (6.3 mmol) Tetrakis-(1-(3-bromphenyl)isochinolinato)(µ-dichlor)-diiridium [Ir(L1Br)₂Cl]₂ werden in einem Gemisch aus 75 ml 2-Ethoxyethanol und 25 ml Wasser suspendiert, mit 1.35 g (13.5 mmol) Acetylaceton [1522-20-9] und 1.59 g (15.0 mmol) Natriumcarbonat versetzt und für 20 h zum Rückfluss erhitzt. Die Heizung wird entfernt, und es werden langsam 75 ml Wasser zur noch warmen Mischung zugetropft. Nach Erkalten wird der gebildete Feststoff über ein Glasfilterfritte abgetrennt, dreimal mit 50 ml Wasser und dreimal mit 50 ml Methanol gewaschen und im Vakuum getrocknet. Der Feststoff wird mit 400 ml Toluol in einem Heißextraktor über etwa 50 g Aluminiumoxid (basisch, Aktivitätsstufe 1) extrahiert. Nach Erkalten wird die Suspension im Vakuum auf etwa 100 ml eingeengt, mit 200 ml Methanol versetzt und für 1 h nachgerührt. Der Feststoff wird abgesaugt, zweimal mit 50 ml Methanol gewaschen und im Vakuum getrocknet. Liegt die Reinheit dann nach ¹H-NMR und/oder HPLC unter 99%, wird der Heißextraktionsschritt entsprechend wiederholt. Es verbleiben 8.97 g (10.4 mmol, 83% der Theorie) als rotes Pulver.

Analog können die Komplexe Ir(L1Br)₂(CL2) bis Ir(L2Br)₂(CL3) hergestellt werden:

| **Bsp.** | **Edukt** | **Co-Ligand CL [CAS]** | **Produkt** | **Ausbeute** |
|---|---|---|---|---|
| Ir(L1Br)₂(CL2) | [Ir(L1Br)₂Cl]₂ | 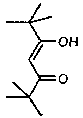 | 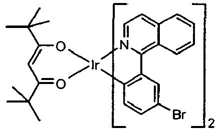 | 79% |
| | | CL2 [55252-75-0] | | |
| Ir(L1Br)₂(CL3) | [Ir(L1Br)₂Cl]₂ | 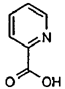 | 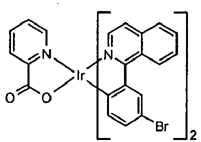 | 70% |
| | | CL3 [98-98-6] | | |
| Ir(L1Br)₂(CL4) | [Ir(L1Br)₂Cl]₂ | 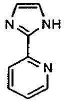 | 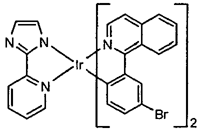 | 73% |
| | | CL4 [18653-75-3] | | |
| Ir(L1Br)₂(CL5) | [Ir(L1Br)₂Cl]₂ | 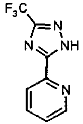 | 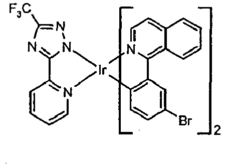 | 61% |
| | | CL5 [219508-27-7] | | |
| Ir(L1Br)₂(CL6) | [Ir(L1Br)₂Cl]₂ | 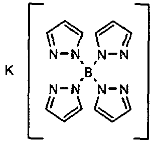 | 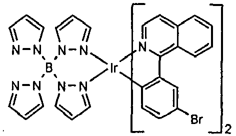 | 60% |
| | | CL6 [14782-58-2] | | |
| Ir(L5Br)₂(CL1) | [Ir(L5Br)₂Cl]₂ | 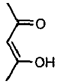 | 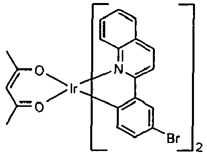 | 78% |
| | | CL1 | | |
| Ir(L5Br)₂(CL2) | [Ir(L5Br)₂Cl]₂ | 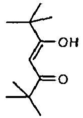 | 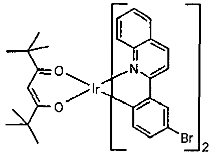 | 73% |
| | | CL2 | | |
| Ir(L2Br)₂(CL1) | [Ir(L2Br)₂Cl]₂ | 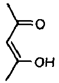 | 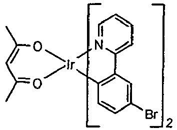 | 85% |
| | | CL1 | | |
| Ir(L2Br)₂(CL2) | [Ir(L2Br)₂Cl]₂ | 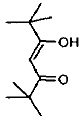 | 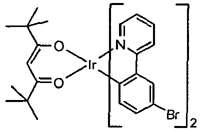 | 86% |
| | | CL2 | | |
| Ir(L2Br)₂(CL3) | [Ir(L2Br)₂Cl]₂ | 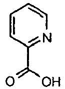 | 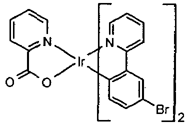 | 75% |
| | | CL3 | | |

### E.2) Ir(L1Br)₂(CL7) / Bis-[1-(3-bromphenyl)isochinolinato]-(2-phenylpyridinato)iridium(III)

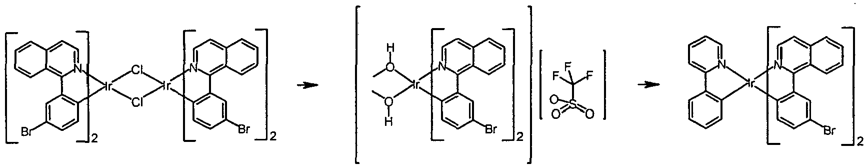

9.53 g (6.0 mmol) [Ir(L1Br)₂Cl]₂ werden in 400 ml Dichlormethan vorgelegt und mit 3.13 g (12.2 mmol) Silbertrifluormethylsulfonsäure und 8 ml (6.34 g, 198 mmol) Methanol für 15 h bei Raumtemperatur gerührt. Die Suspension wird über Celite filtriert und das Filtrat im Vakuum bis auf etwa 50 ml eingeengt. Die Mischung wird mit 200 ml Heptan versetzt und für 1 h gerührt. Der gebildete Feststoff wird über eine Glasfilterfritte abgetrennt, zweimal mit etwa 75 ml Heptan gewaschen und im Hochvakuum (Druck etwa 10⁻⁵ mbar) getrocknet. Der verbleibende Rückstand wird in 500 ml Ethanol suspendiert, mit 1.83 g (11.8 mmol) 2-Phenylpyridin und 1.54 g (14.4 mmol) 2,6-Dimethylpyridin versetzt und für 48 h zum Rückfluss erhitzt. Der Feststoff wird über eine Glasfilterfritte abgetrennt, dreimal mit etwa 50 ml Ethanol gewaschen und im Vakuum getrocknet. Der verbleibende Rückstand wird in 250 ml Ethylenglykol suspendiert und für 8 h auf 190 °C erhitzt. Die Heizung wird entfernt; nach Abkühlen auf etwa 80 °C wird mit 400 ml Ethanol versetzt und für 24 h gerührt. Der Feststoff wird über eine Glasfilterfritte abgetrennt, zweimal mit etwa 50 ml Ethanol gewaschen und im Hochvakuum (Druck etwa 10⁻⁵ mbar) getrocknet. Es verbleiben 6.71 g (7.3 mmol, 61% der Theorie) des nach ¹H-NMR etwa 98%igen Produkt als rotes Pulver.

In analoger Weise können die Vorstufen Ir(L5Br)₂(CL7) bis Ir(L2Br)₂(L16) hergestellt werden:

| **Bsp.** | **Edukt** | **Co-Ligand CL [CAS]** | **Produkt** | **Ausbeute** |
|---|---|---|---|---|
| Ir(L5Br)₂(CL7) | [Ir(L5Br)₂Cl]₂ | 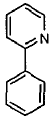 | 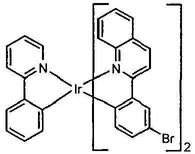 | 52% |
| | | CL7 [1008-89-5] | | |
| Ir(L1Br)₂(CL8) | [Ir(L1Br)₂Cl]₂ | 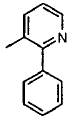 | 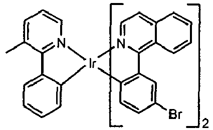 | 65% |
| | | CL8 [10273-90-2] | | |
| Ir(L1Br)₂(CL9) | [Ir(L1Br)₂Cl]₂ | 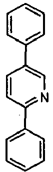 | 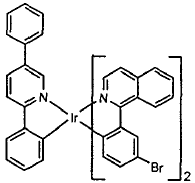 | 59% |
| | | CL9 [15827-72-2] | | |
| Ir(L1Br)₂(CL10) | [Ir(L1Br)₂Cl]₂ | 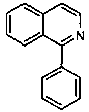 | 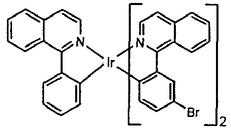 | 47% |
| | | CL10 [3297 -72-1] | | |
| Ir(L1Br)₂(CL11) | [Ir(L1Br)₂Cl]₂ | 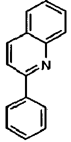 | 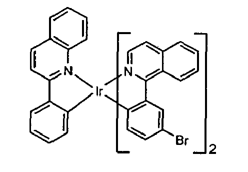 | 50% |
| | | CL11 [612-96-4] | | |
| Ir(L1Br)₂(CL12) | [Ir(L1Br)₂Cl]₂ | 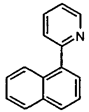 | 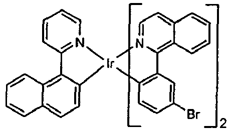 | 42% |
| | | CL12 [76759-26-7] | | |
| Ir(L1Br)₂(L6) | [Ir(L1Br)₂Cl]₂ | 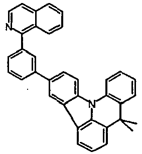 | 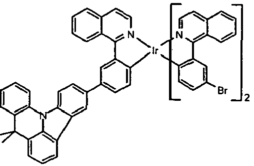 | 53% |
| | | L6 | | |
| Ir(L5Br)₂(L6) | [Ir(L5Br)₂Cl]₂ | 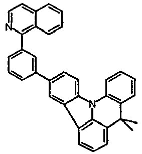 | 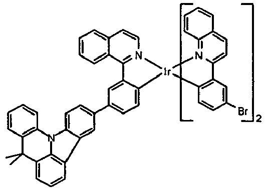 | 36% |
| | | L6 | | |
| Ir(L1Br)₂(L7) | [Ir(L1Br)₂Cl]₂ | 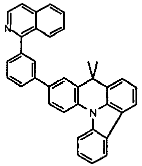 | 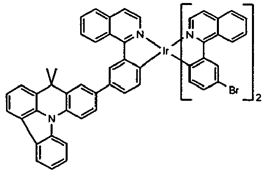 | 48% |
| | | L7 | | |
| Ir(L1Br)₂(L8) | [Ir(L1Br)₂Cl]₂ | 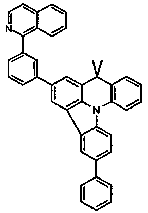 | 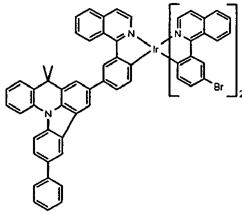 | 55% |
| | | L8 | | |
| Ir(L5Br)₂(L8) | [Ir(L5Br)₂Cl]₂ | 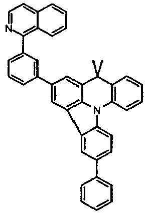 | 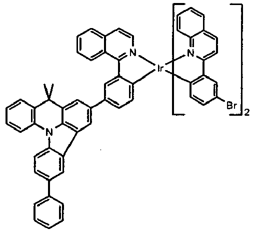 | 39% |
| | | L8 | | |
| Ir(L1Br)₂(L9) | [Ir(L1Br)₂Cl]₂ | 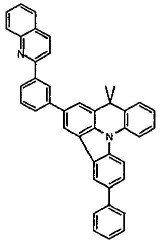 | 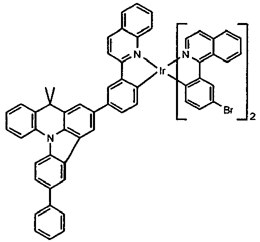 | 49% |
| | | L9 | | |
| Ir(L1Br)₂(L10) | [Ir(L1Br)₂Cl]₂ | 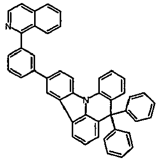 | 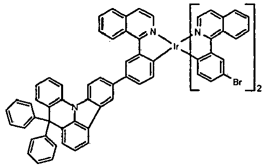 | 65% |
| | | L10 | | |
| Ir(L1Br)₂(L11) | [Ir(L1Br)₂Cl]₂ | 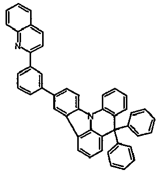 | 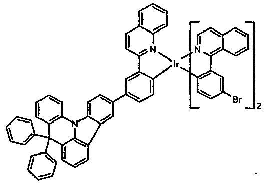 | 56% |
| | | L11 | | |
| Ir(L1Br)₂(L12) | [Ir(L1Br)₂Cl]₂ | 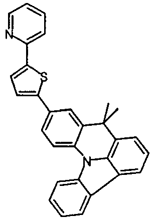 | 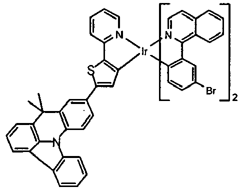 | 61% |
| | | L12 | | |
| Ir(L1Br)₂(L13) | [Ir(L1Br)₂Cl]₂ | 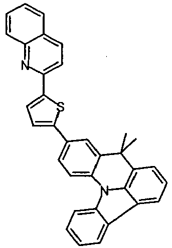 | 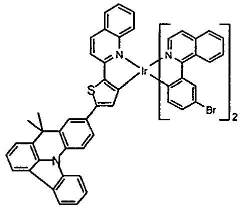 | 47% |
| | | L13 | | |
| Ir(L1Br)₂(L14) | [Ir(L1Br)₂Cl]₂ | 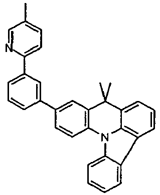 | 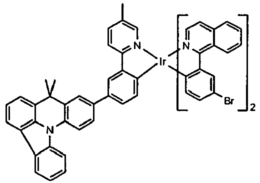 | 52% |
| | | L14 | | |
| Ir(L2Br)₂(L15) | [Ir(L2Br)₂Cl]₂ | 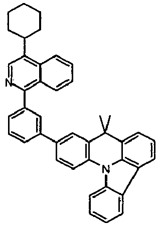 | 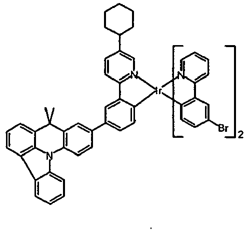 | 63% |
| | | L15 | | |
| Ir(L2Br)₂(L16) | [Ir(L2Br)₂Cl]₂ | 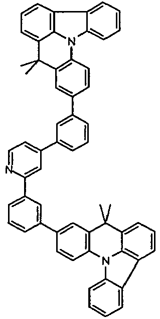 | 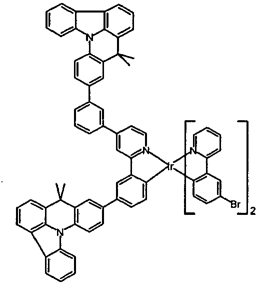 | 25% |
| | | L16 | | |
| Ir(L2Br)₂(L15) | [Ir(L2Br)₂Cl]₂ | 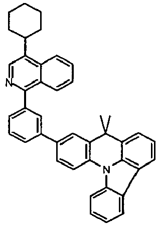 | 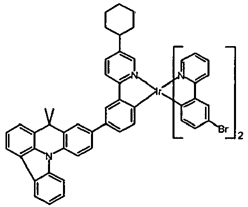 | 63% |
| | | L15 | | |
| Ir(L2Br)₂(L16) | [Ir(L2Br)₂Cl]₂ | 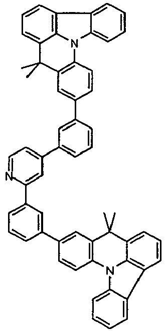 | 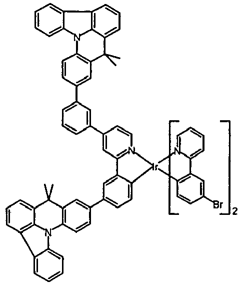 | 25% |
| | | L16 | | |

### F) Herstellung der erfindungsgemäßen Komplexe

### F.1) Homoleptische 1-Phenylisochinolin-Iridium-Komplexe

### K1 / Tris-{1-[3-(8,8-dimethyl-8H-indolo[3,2,1-de]acridin-3-yl)phen-1-yl]-isochinolinato}iridium(III)

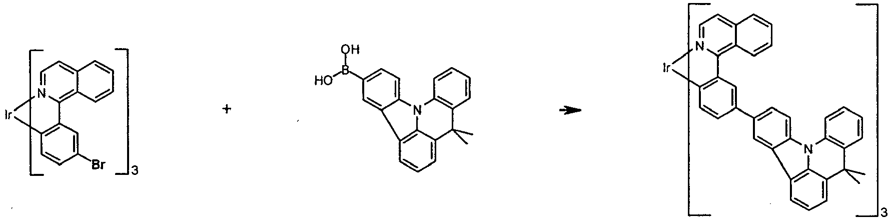

7.50 g (7.2 mmol)Ir(L1Br)₃, 7.10 g (21.7 mmol) 8,8-Dimethyl-8H-indolo-[3,2,1-de]acridin-3-yl-boronsäure [1307793-50-5], 12.62 g (54.8 mmol) Kaliumphosphat-Monohydrat, 49.4 mg (0.22 mmol) Palladium(II)acetat und 0.3 ml (0.30 mmol) Tri-*t*-butylphosphin-Lösung (1M in Toluol) werden in einem Gemisch aus 150 ml Toluol, 100 ml Dioxan und 175 ml Wasser unter kräftigem Rühren für 15 h zum Rückfluss erhitzt. Nach Abkühlen auf Raumtemperatur werden die Phasen getrennt. Die wässrige Phase wird dreimal mit je 100 ml Toluol und zweimal mit je 100 ml Dichlormethan gewaschen. Die vereinigten organischen Phasen werden dreimal mit je 250 ml Wasser gewaschen, über MgSO₄ getrocknet und im Vakuum auf etwa 150 ml eingeengt. 450 ml Ethanol werden unter Rühren langsam zugetropft, dann wird die Suspension für 1 h nachgerührt. Der Feststoff wird abgesaugt, zweimal mit je 50 ml Ethanol gewaschen, im Vakuum getrocknet und anschließend in einem Heißextraktor mit etwa 250 ml Toluol über 75 g Aluminiumoxid (basisch, Aktivitätsstufe 1) extrahiert. Das Lösungsmittel wird im Vakuum auf etwa 75 ml eingeengt. Die Suspension wird 1 h nachgerührt, dann wird der Feststoff abgesaugt und im Vakuum getrocknet. Das Produkt wird chromatographisch über Kieselgel mit einem THF/MeOH-Gemisch (90:10 vv) gereinigt, im Vakuum vom Lösungsmittel befreit und abschließend im Hochvakuum (Druck ca. 10⁻⁶ mbar) bei 300 °C getempert. Es verbleiben 4.95 g (3.0 mmol, 42% der Theorie) als rotes Pulver mit einer Reinheit von 99.8% nach HPLC.

In analoger Weise können die Komplexe K2 bis K36 hergestellt werden. Bei zu geringer Löslichkeit in Toluol kann die Heißextraktion gegebenenfalls mit Chlorbenzol oder Dichlorbenzol durchgeführt werden. Beispielhafte typische Laufmittel für die chromatographische Reinigung sind THF/MeOH, Dichlormethan/Heptan, Dichlormethan/Essigester, Toluol/Essigester und reines Toluol.

| **Bsp.** | **Boronsäure(ester) [CAS] bzw. Bsp.** | **Produkt** | **Ausbeute** |
|---|---|---|---|
| K2 | 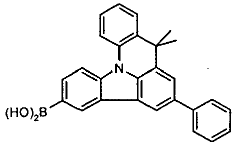 | 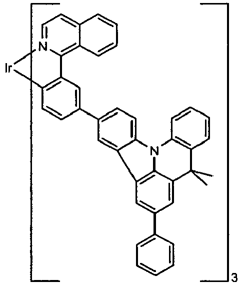 | 47% |
| | [1319016-13-1] | | |
| K3 | 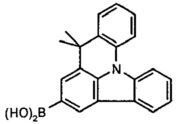 | 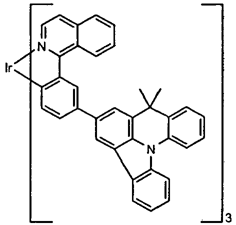 | 52% |
| | [1289472-63-4] | | |
| K4 | 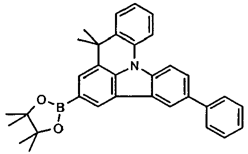 | 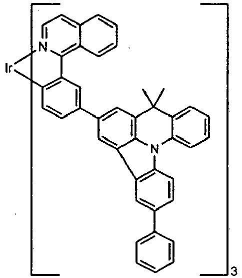 | 61% |
| | BS1 | | |
| K5 | 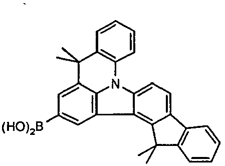 | 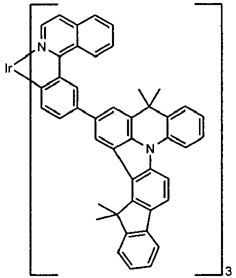 | 39% |
| | [1346645-69-9] | | |
| K6 | 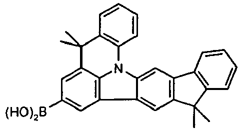 | 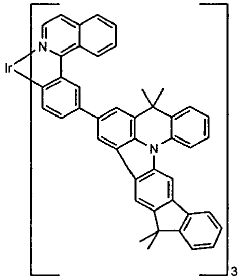 | 32% |
| | [1346645-63-3] | | |
| K7 | 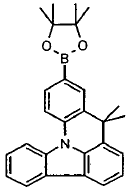 BS2 | 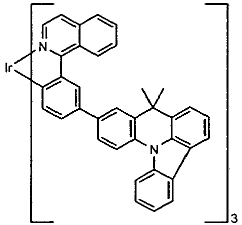 | 58% |
| | | | |
| K8 | 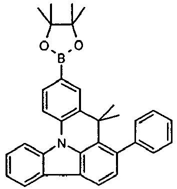 | 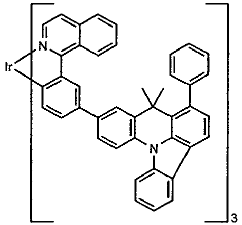 | 44% |
| | BS3 | | |
| K9 | 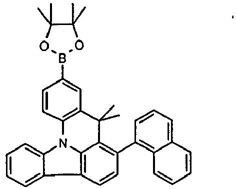 | 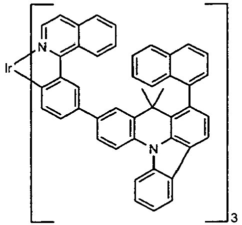 | 31% |
| | BS4 | | |
| K10 | 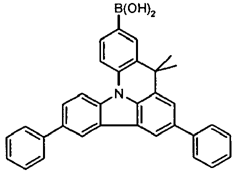 | 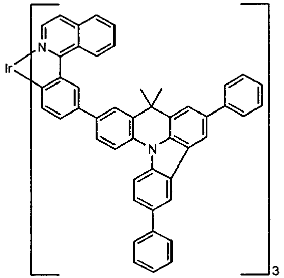 | 47% |
| | [1319016-15-3] | | |
| K11 | 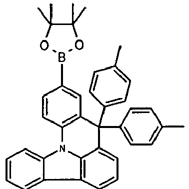 | 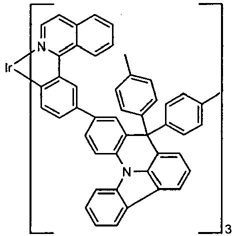 | 52% |
| | BS5 | | |
| K12 | 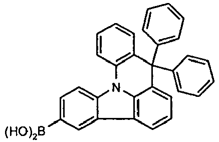 | 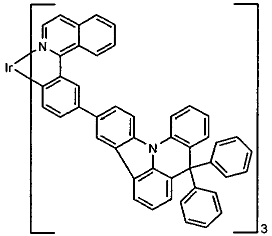 | 57% |
| | [1290058-09-1 | | |
| K13 | 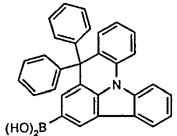 | 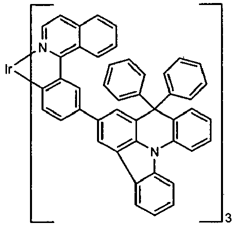 | 40% |
| | [1290058-12-6] | | |
| K14 | 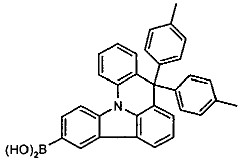 | 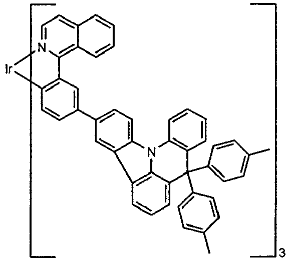 | 52% |
| | [131016-75-5] | | |
| K15 | 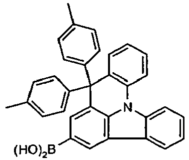 | 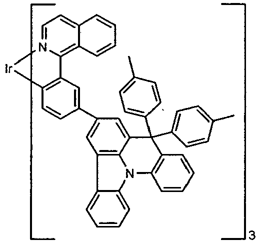 | 43% |
| | [1290058-10-4] | | |
| K16 | 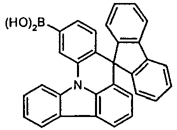 | 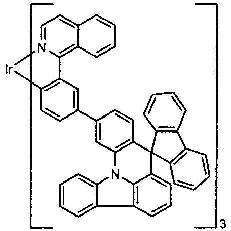 | 38% |
| | [1361956-38-8 | | |
| K17 | 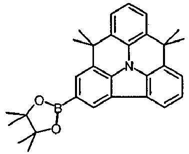 | 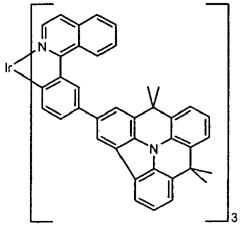 | 11% |
| | BS6 | | |
| K18 | 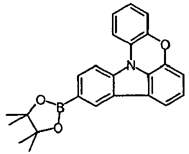 | 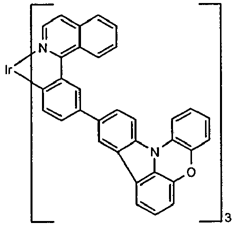 | 33% |
| | [1380485-64-2] | | |
| K19 | 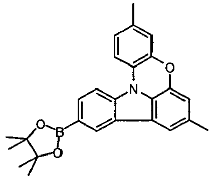 | 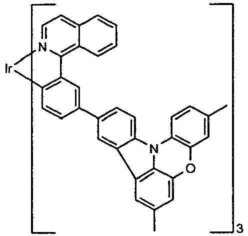 | 38% |
| | [1380485-72-2] | | |
| K20 | 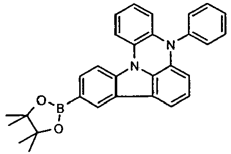 | 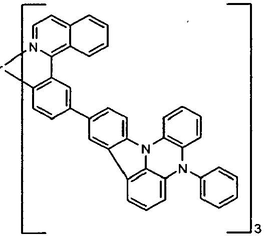 | 42% |
| | BS7 | | |
| K21 | 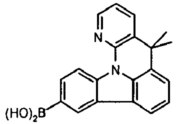 | 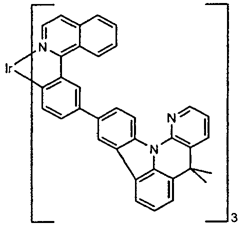 | 42% |
| | [1309461-01-5] | | |
| K22 | 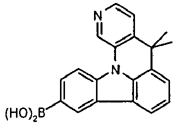 | 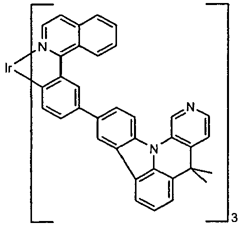 | 39% |
| | [1309461-00-4] | | |
| K23 | 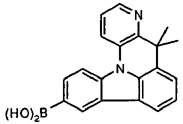 | 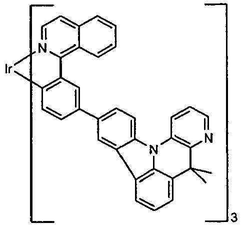 | 47% |
| | [1309460-99-8] | | |
| K24 | 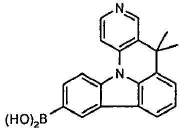 | 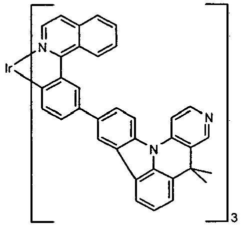 | 46% |
| | [1309460-95-4] | | |
| K25 | 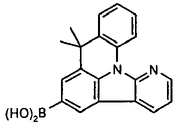 | 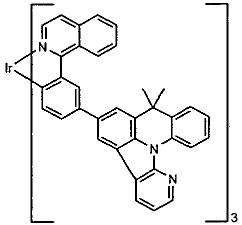 | 51% |
| | [1309460-98-7] | | |
| K26 | 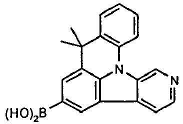 | 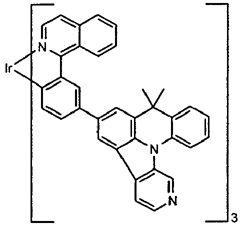 | 48% |
| | [1309460-97-6] | | |
| K27 | 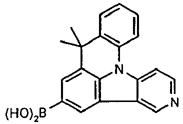 | 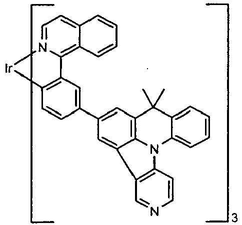 | 36% |
| | [1309460-96-5] | | |
| K28 | 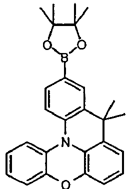 | 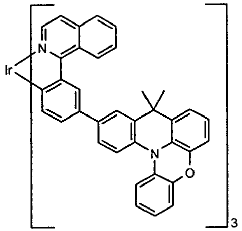 | 28% |
| | [1380170-35-3] | | |
| K29 | 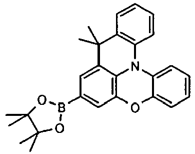 | 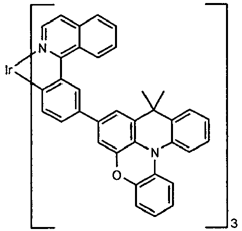 | 37% |
| | BS8 | | |
| K30 | 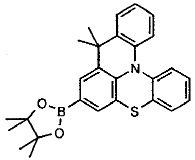 | 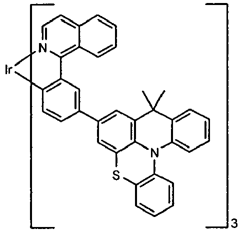 | 32% |
| | BS9 | | |
| K31 | 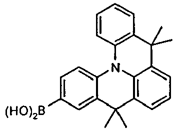 | 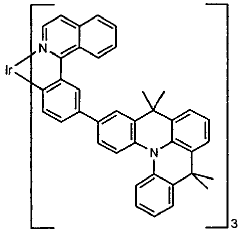 | 21% |
| | [1333316-11-2] | | |
| K32 | 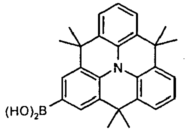 | 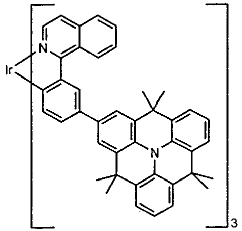 | 4% |
| | [1172087-67-0] | | |
| K33 | 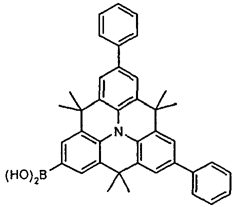 | 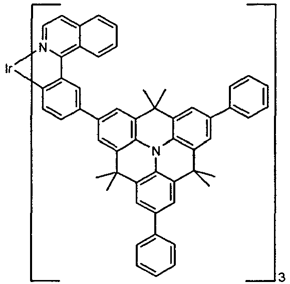 | 9% |
| | [1172087-72-7] | | |
| K34 | 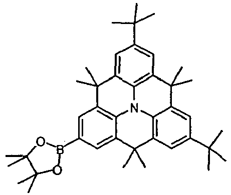 | 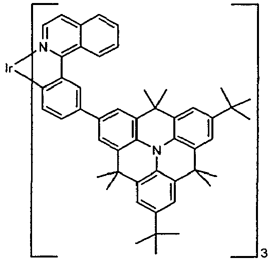 | 16% |
| | [1391634-73-3] | | |
| K35 | 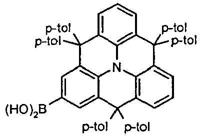 | 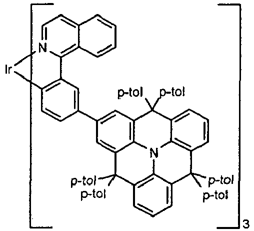 | 11% |
| | [1345029-46-0] | | |
| K36 | 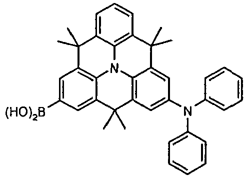 | 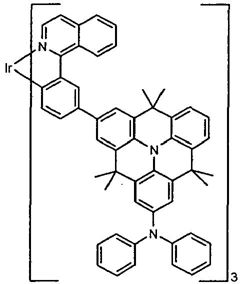 | 17% |
| | [1207594-63-5] | | |

### F.2) Homoleptische 3-Phenylisochinolin-Iridium-Komplexe

Analog zum unter F.1 beschriebenen Verfahren können aus Ir(L3Br)₃ die Komplexe K37 bis K42 hergestellt werden:

| **Bsp.** | **Boronsäure(ester) [CAS] bzw. Bsp.** | **Produkt** | **Ausbeute** |
|---|---|---|---|
| K37 | 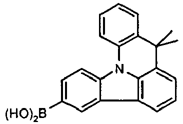 | 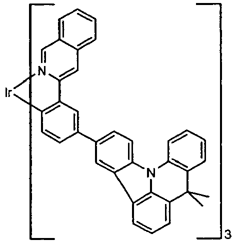 | 39% |
| | [1307793-50-5] | | |
| K38 | 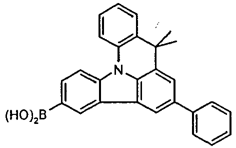 | 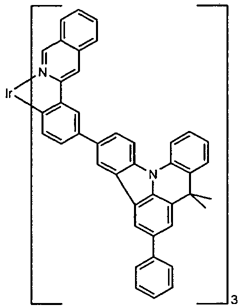 | 48% |
| | [1319016-13-1] | | |
| K39 | 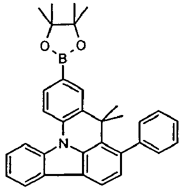 | 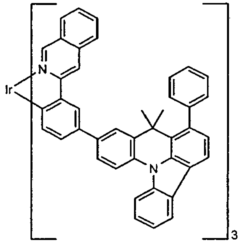 | 36% |
| | BS3 | | |
| K40 | 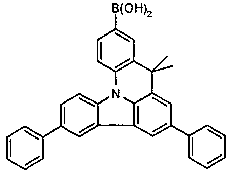 | 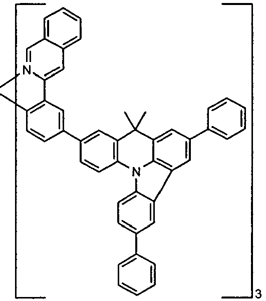 | 51% |
| | [1319016-15-3] | | |
| K41 | 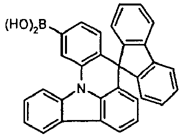 | 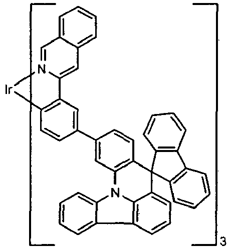 | 49% |
| | [1361956-38-8] | | |
| K42 | 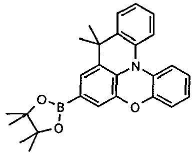 | 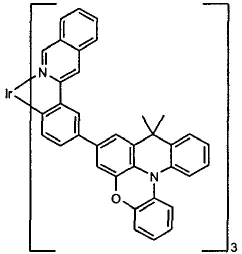 | 28% |
| | BS8 | | |

### F.3) Homoleptische 2-Phenylpyridin-Iridium-Komplexe

Analog zum unter F.1 beschriebenen Verfahren können aus Ir(L2Br)₃ die Komplexe K43 bis K58 hergestellt werden:

| **Bsp.** | **Boronsäure(ester) [CAS] bzw. Bsp.** | **Produkt** | **Ausbeute** |
|---|---|---|---|
| K43 | 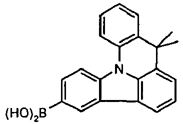 | 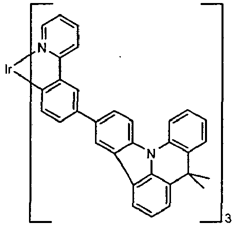 | 57% |
| | [1307793-50-5] | | |
| K44 | 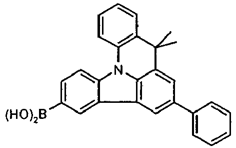 | 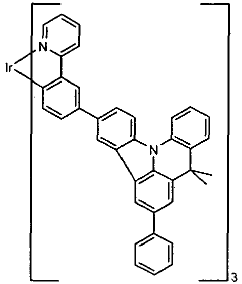 | 48% |
| | [1319016-13-1] | | |
| K45 | 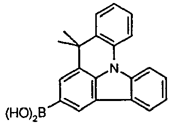 | 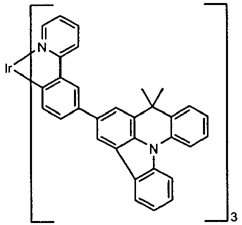 | 41% |
| | [1289472-63-4] | | |
| K46 | 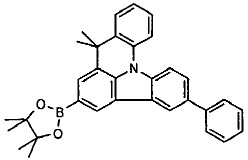 | 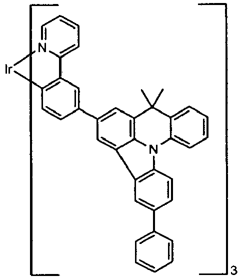 | 49% |
| | BS1 | | |
| K47 | 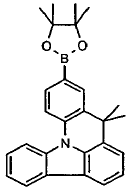 | 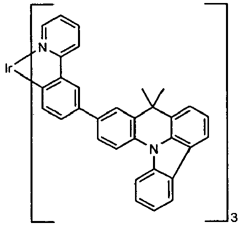 | 44% |
| | BS2 | | |
| K48 | 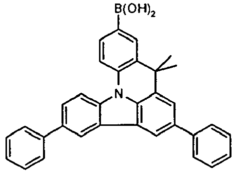 | 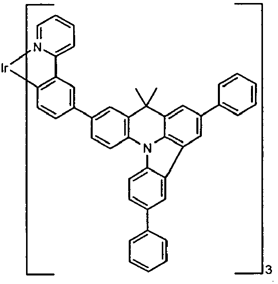 | 53% |
| | [1319016-15-3] | | |
| K49 | 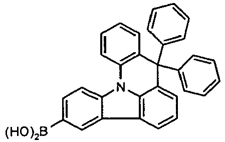 | 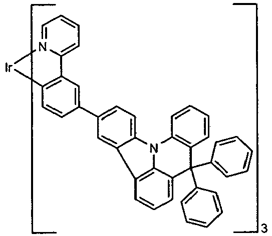 | 36% |
| | [1290058-09-1] | | |
| K50 | 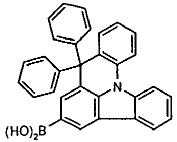 | 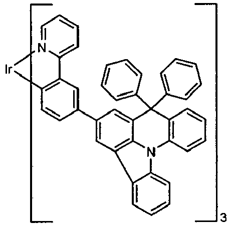 | 21% |
| | [1290058-12-6] | | |
| K51 | 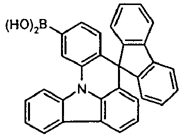 | 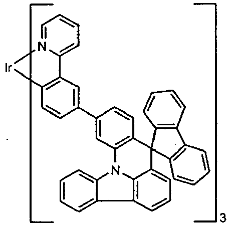 | 29% |
| | [1361956-38-8] | | |
| K52 | 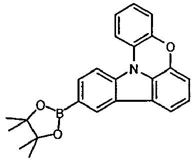 | 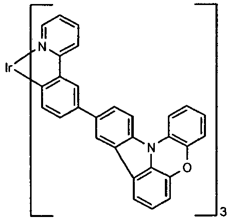 | 32% |
| | [1380485-64-2] | | |
| K53 | 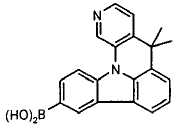 | 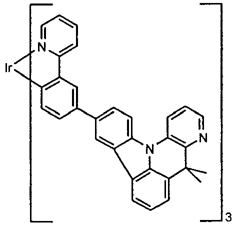 | 41% |
| | [1309461-00-4] | | |
| K54 | 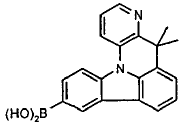 | 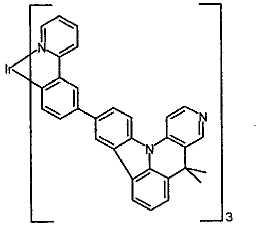 | 38% |
| | [1309460-99-8] | | |
| K55 | 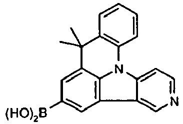 | 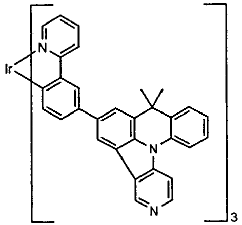 | 27% |
| | [1309460-96-5] | | |
| K56 | 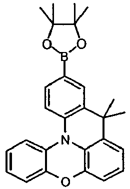 | 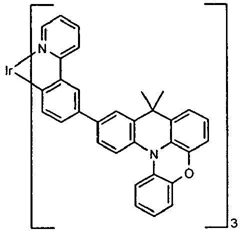 | 17% |
| | [1380170-35-3] | | |
| K57 | 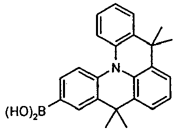 | 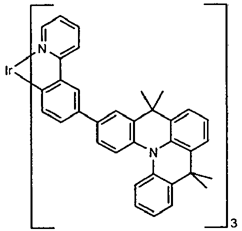 | 39% |
| | [1333316-11-2] | | |
| K58 | 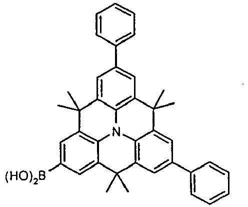 | 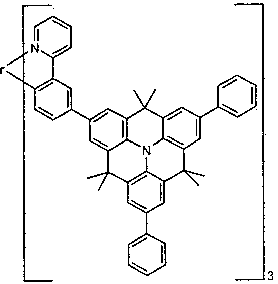 | 8% |
| | [1172087-72-7] | | |

### F.4) Homoleptische Benzo[4,5]imidazo[1,2-c]chinazolin-Iridium-Komplexe

Analog zum unter F.1 beschriebenen Verfahren können aus Ir(L4Br)₃ die Komplexe K59 bis K66 hergestellt werden:

| **Bsp.** | **Boronsäure(ester) [CAS] bzw. Bsp.** | **Produkt** | **Ausbeute** |
|---|---|---|---|
| K59 | 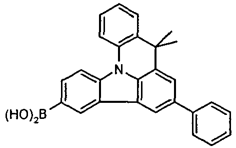 | 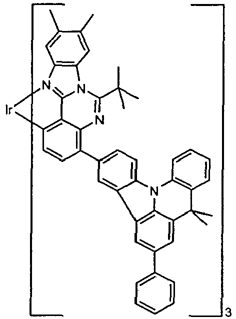 | 40% |
| | [1319016-13-1] | | |
| K60 | 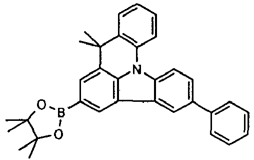 | 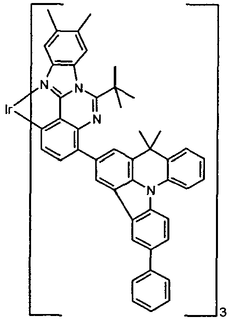 | 38% |
| | BS1 | | |
| K61 | 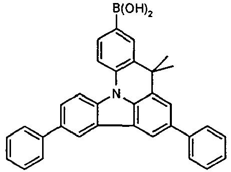 | 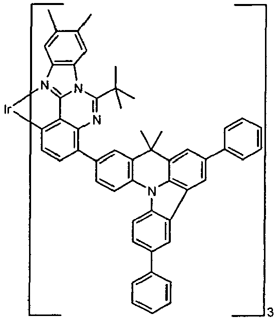 | 52% |
| | [1319016-15-3] | | |
| K62 | 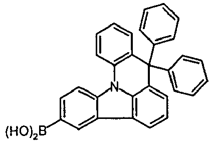 | 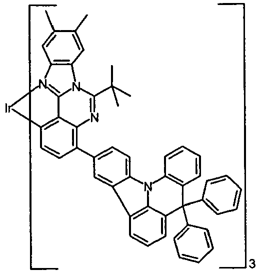 | 39% |
| | [1290058-09-1] | | |
| K63 | 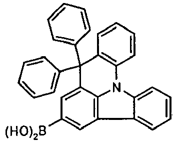 | 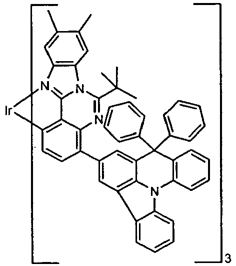 | 28% |
| | [1290058-12-6] | | |
| K64 | 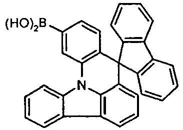 | 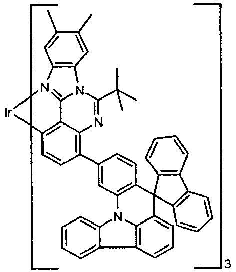 | 12% |
| | [1361956-38-8] | | |
| K65 | 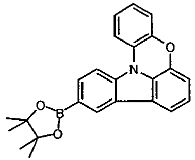 | 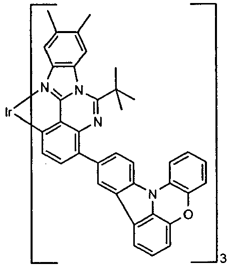 | 23% |
| | [1380485-64-2] | | |
| K66 | 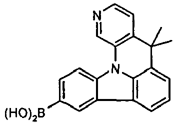 | 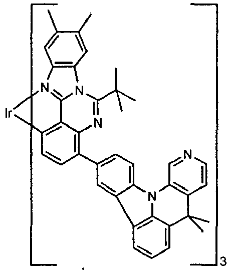 | 17% |
| | [1309461-00-4] | | |

### F.5) Heteroleptische Komplexe

### F.5.1) K67 / (O,O'-Acetylacetonato)-bis-{1-[3-(8,8-dimethyl-8H-indolo-[3,2,1-de]acridin-3-yl)phen-1-yl]isochinolinato}iridium(III)

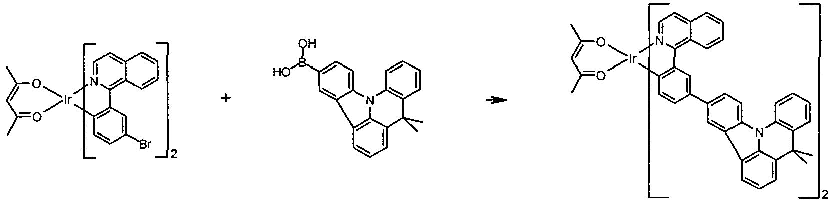

6.78 g (7.9 mmol) Ir(L1Br)₂(CL1), 5.24 g (16.0 mmol) 8,8-Dimethyl-8H-indolo[3,2,1-de]acridin-3-yl-boronsäure [1307793-50-5], 3.07 g (52.8 mmol) Kaliumfluorid, 44.9 mg (0.20 mmol) Palladium(II)acetat und 0.3 ml (0.3 mmol) Tri-*t*-butylphosphin-Lösung (1M in Toluol) werden in 300 ml THF unter kräftigem Rühren für 12 h zum Rückfluss erhitzt. Nach Abkühlen auf Raumtemperatur wird das Lösungsmittel im Vakuum vollständig entfernt. Der verbleibende Rückstand wird in einem Heißextraktor mit 250 ml Toluol über etwa 50 g Aluminiumoxid (basisch, Aktivitätsstufe 1) extrahiert. Das Lösungsmittel wird im Vakuum entfernt und der verbleibende Rückstand über Kieselgel mit einem THF/MeOH-Gemisch (98:2 vv) chromatographisch gereinigt. Das Lösungsmittel wird im Vakuum entfernt und der Rückstand im Hochvakuum (Druck etwa 10⁻⁶ mbar) bei 250 °C getempert. Es verbleiben 2.79 g (2.2 mmol, 28% der Theorie) als rotes Pulver mit einer Reinheit von 99.9% nach HPLC.

In analoger Weise können die Komplexe K68 bis K85 hergestellt werden. Beispielhafte typische Laufmittel für die chromatographische Reinigung sind THF/MeOH, Dichlormethan/Heptan, Dichlormethan/Essigester, Toluol/Essigester und reines Toluol.

| **Bsp.** | **Ir-Edukt** | **Boronsäure(ester) [CAS] bzw. Bsp.** | **Produkt** | **Ausbeute** |
|---|---|---|---|---|
| K68 | Ir(L1Br)₂(CL2) | 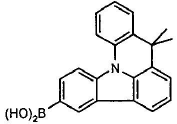 | 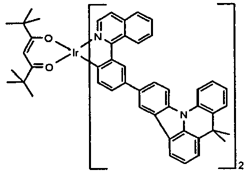 | 43% |
| | | [1307793-50-5] | | |
| K69 | Ir(L1Br)₂(CL2) | 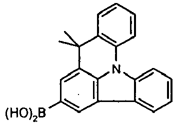 | 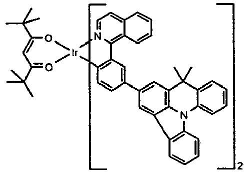 | 36% |
| | | [1289472-63-4] | | |
| K70 | Ir(L1Br)₂(CL2) | 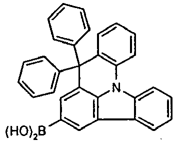 | 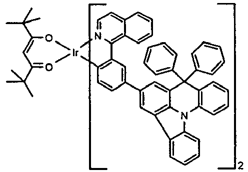 | 29% |
| | | [1290058-12-6] | | |
| K71 | Ir(L1Br)₂(CL2) | 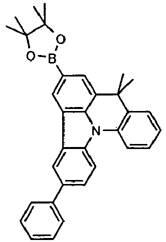 | 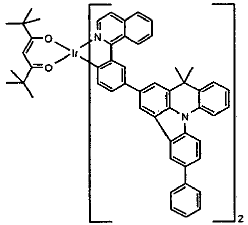 | 44% |
| | | BS1 | | |
| K72 | Ir(L1Br)₂(CL2) | 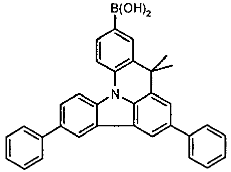 | 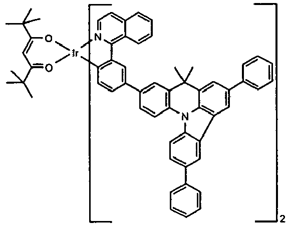 | 39% |
| | | [1319016-15-3] | | |
| K73 | Ir(L1Br)₂(CL2) | 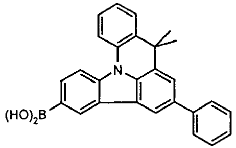 | 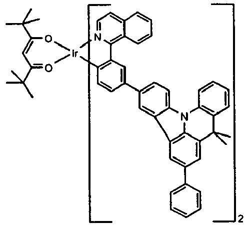 | 41% |
| | | [1319016-13-1] | | |
| K74 | Ir(L1Br)₂(CL3) | 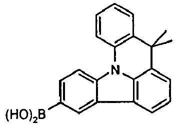 | 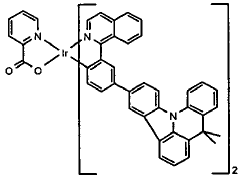 | 27% |
| | | [1307793-50-5] | | |
| K75 | Ir(L1Br)₂(CL4) | 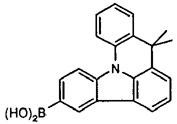 | 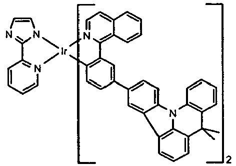 | 33% |
| | | [1307793-50-5] | | |
| K76 | Ir(L1Br)₂(CL5) | 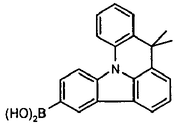 | 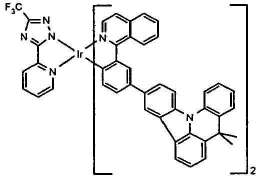 | 38% |
| | | [1307793-50-5] | | |
| K77 | Ir(L1Br)₂(CL6) | 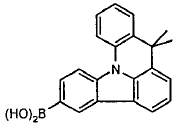 | 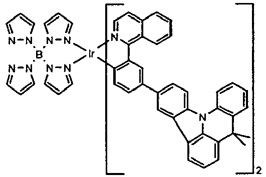 | 19% |
| | | [1307793-50-5] | | |
| K78 | Ir(L5Br)₂(CL1) | 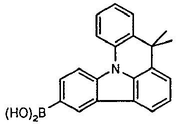 | 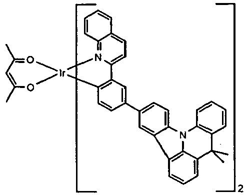 | 42% |
| | | [1307793-50-5] | | |
| K79 | Ir(L2Br)₂(CL1) | 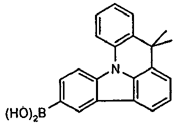 | 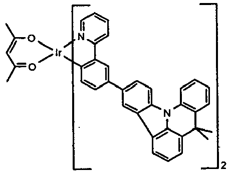 | 57% |
| | | [1307793-50-5] | | |
| K80 | Ir(L2Br)₂(CL2) | 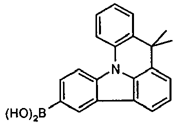 | 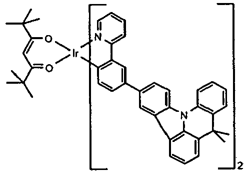 | 43% |
| | | [1307793-50-5] | | |
| K81 | Ir(L2Br)₂(CL2) | 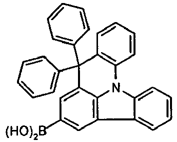 | 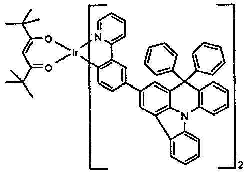 | 28% |
| | | [1290058-12-6] | | |
| K82 | Ir(L2Br)₂(CL2) | 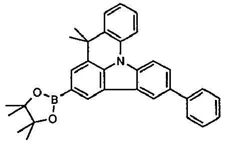 | 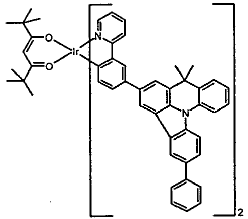 | 35% |
| | | BS1 | | |
| K83 | Ir(L2Br)₂(CL2) | 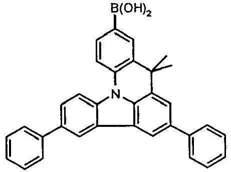 | 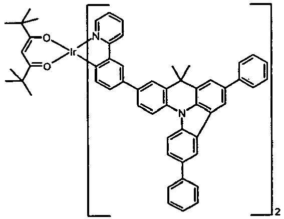 | 31% |
| | | [1319016-15-3] | | |
| K84 | Ir(L2Br)₂(CL2) | 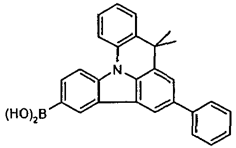 | 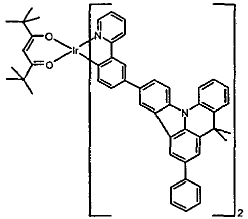 | 36% |
| | | [1319016-13-1] | | |
| K85 | Ir(L2Br)₂(CL3) | 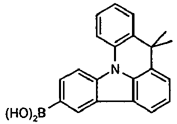 | 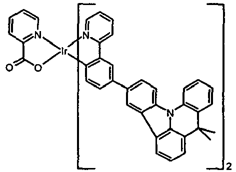 | 40% |
| | | [1307793-50-5] | | |

### F.5.2) K86 / Bis-{1-[3-(8,8-dimethyl-8H-indolo[3,2,1-de]acridin-3-yl)phen-1-yl]isochinolinato}-(2-phenylpyridinato)iridium(III)

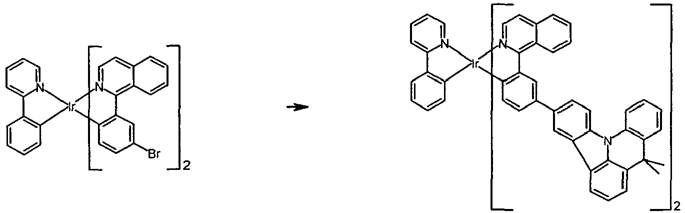

3.65 g (4.0 mmol) Bis-[1-(3-bromphenyl)isochinolinato]-(2-phenyl-pyridinato)iridium(III) werden mit 2.91 g (8.9 mmol) 8,8-Dimethyl-8H-indolo-[3,2,1-de]acridin-3-yl-boronsäure [1307793-50-5], 4.15 g (18.0 mmol) Kaliumphosphat-Monohydrat, 53.9 mg (0.24 mmol) Palladium(II)acetat und 0.3 ml (0.30 mmol) Tri-*t*-butylphosphin-Lösung (1M in Toluol) in einem Gemisch aus 150 ml Toluol, 100 ml Dioxan und 50 ml Wasser unter kräftigem Rühren für 15 h zum Rückfluss erhitzt. Nach Abkühlen auf Raumtemperatur werden die Phasen getrennt. Die wäßrige Phase wird dreimal mit je 100 ml Toluol gewaschen. Die vereinigten organischen Phasen werden dreimal mit je 250 ml Wasser gewaschen, über MgSO₄ getrocknet und im Vakuum auf etwa 150 ml eingeengt. 450 ml Ethanol werden unter Rühren langsam zugetropft, dann wird die Suspension für 1 h nachgerührt. Der Feststoff wird abgesaugt, zweimal mit je 50 ml Ethanol gewaschen, im Vakuum getrocknet und anschließend in einem Heißextraktor mit etwa 250 ml Xylol über 50 g Aluminiumoxid (basisch, Aktivitätsstufe 1) extrahiert. Das Lösungsmittel wird im Vakuum auf etwa 50 ml eingeengt. Die Suspension wird 1 h nachgerührt, dann wird der Feststoff abgesaugt und im Vakuum getrocknet. Das Produkt wird chromatographisch über Kieselgel mit einem Heptan/Dichlormethan-Gemisch (90:10 vv) gereinigt, im Vakuum vom Lösungsmittel befreit und abschließend im Hochvakuum (Druck etwa 10⁻⁶ mbar) bei 300 °C getempert. Es verbleiben 2.16 g (1.6 mmol, 41% der Theorie) als rotes Pulver mit einer Reinheit von 99.8% nach HPLC.

In analoger Weise können die Komplexe K87 bis K108 hergestellt werden:

| **Bsp.** | **Edukt 1** | **Edukt 2 [CAS] bzw. Bsp.** | **Produkt** | **Aus-beute** |
|---|---|---|---|---|
| K87 | Ir(L5Br)₂(CL7) | 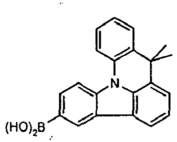 | 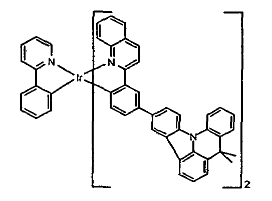 | 47% |
| | | [1307793-50-5] | | |
| K88 | Ir(L5Br)₂(CL7) | 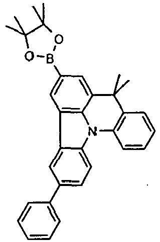 | 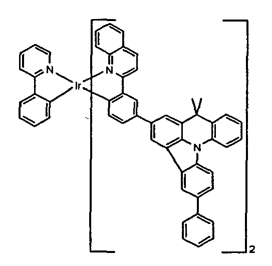 | 38% |
| | | BS1 | | |
| K89 | Ir(L1Br)₂(CL8) | 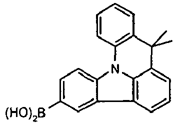 | 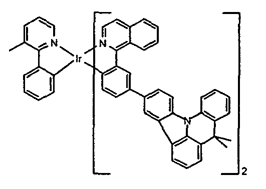 | 42% |
| | | [1307793-50-5] | | |
| K90 | Ir(L1Br)₂(CL9) | 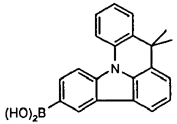 | 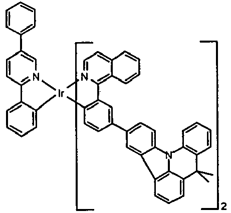 | 39% |
| | | [1307793-50-5] | | |
| K91 | Ir(L1Br)₂(CL10) | 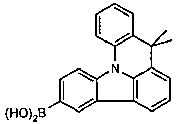 | 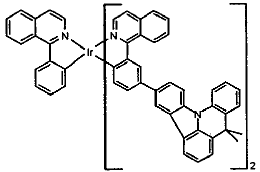 | 38% |
| | | [1307793-50-5] | | |
| K92 | Ir(L1Br)₂(CL10) | 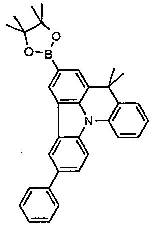 | 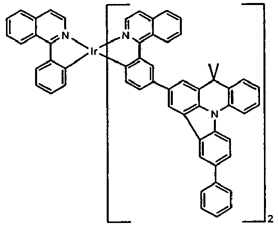 | 28% |
| | | BS1 | | |
| K93 | Ir(L1Br)₂(CL11) | 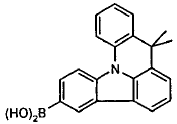 | 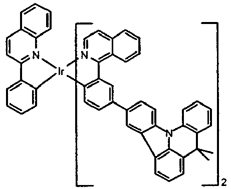 | 31% |
| | | [1307793-50-5] | | |
| K94 | Ir(L1Br)₂(CL12) | 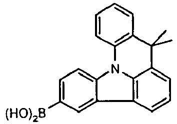 | 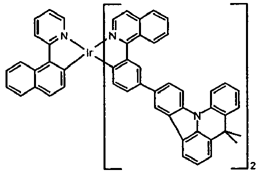 | 40% |
| | | [1307793-50-5] | | |
| K95 | Ir(L1Br)₂(L6) | 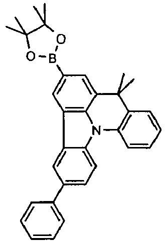 | 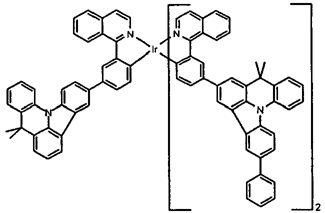 | 34% |
| | | BS1 | | |
| K96 | Ir(L5Br)₂(L6) | 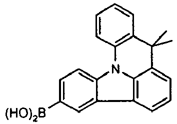 | 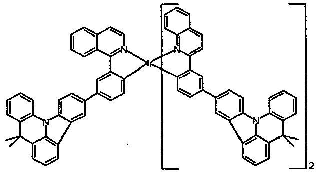 | 21% |
| | | [1307793-50-5] | | |
| K97 | Ir(L5Br)₂(L6) | 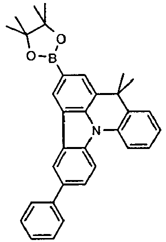 | 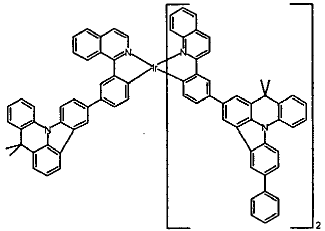 | 17% |
| | | BS1 | | |
| K98 | Ir(L1Br)₂(L7) | 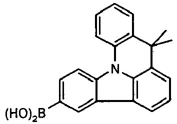 | 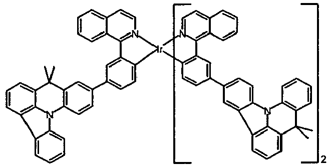 | 32% |
| | | [1307793-50-5] | | |
| K99 | Ir(L1Br)₂(L8) | 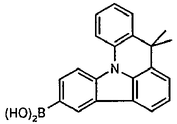 | 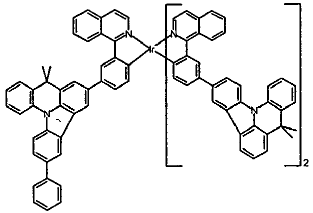 | 39% |
| | | [1307793-50-5] | | |
| K100 | Ir(L5Br)₂(L8) | 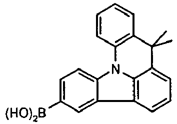 | 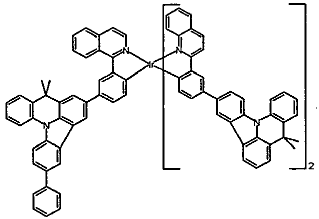 | 21% |
| | | [1307793-50-5] | | |
| K101 | Ir(L1Br)₂(L9) | 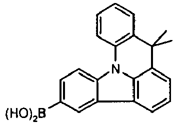 | 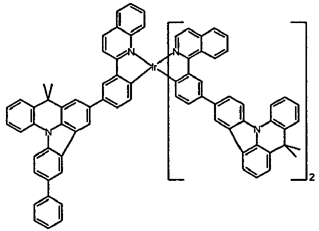 | 15% |
| | | [1307793-50-5] | | |
| K102 | Ir(L1Br)₂(L10) | 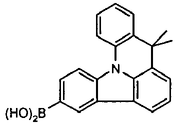 | 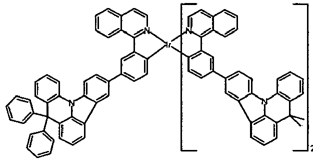 | 27% |
| | | [1307793-50-5] | | |
| K103 | Ir(L1Br)₂(L11) | 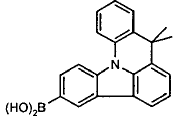 | 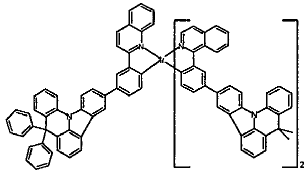 | 12% |
| | | [1307793-50-5] | | |
| K104 | Ir(L1Br)₂(L12) | 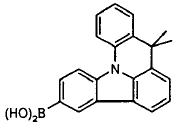 | 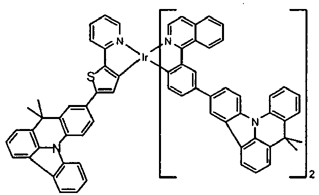 | 24% |
| | | [1307793-50-5] | | |
| K105 | Ir(L1Br)₂(L13) | 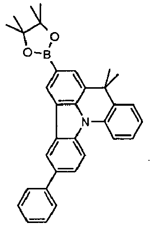 | 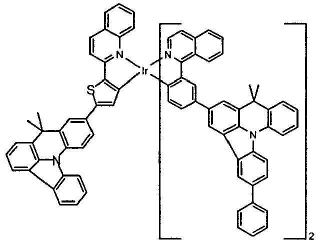 | 19% |
| | | BS1 | | |
| K106 | Ir(L1Br)₂(L14) | 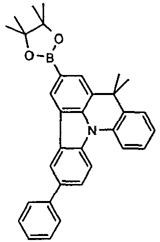 | 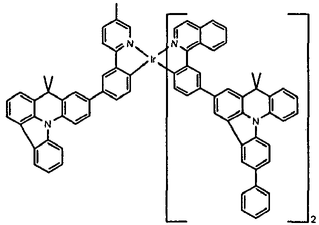 | 37% |
| | | BS1 | | |
| K107 | Ir(L2Br)₂(L15) | 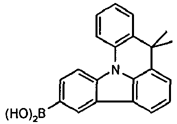 | 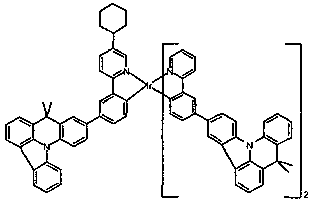 | 38% |
| | | [1307793-50-5] | | |
| K108 | Ir(L2Br)₂(L16) | 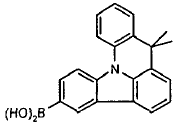 | 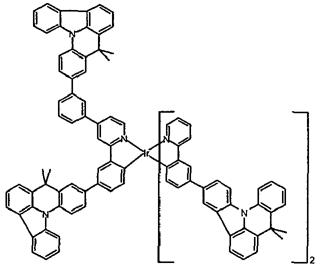 | 33% |
| | | [1307793-50-5] | | |

### G) Herstellung von K109 / Bis-{1-[3-(8,8-dimethyl-8H-indolo[3,2,1-de]acridin-3-yl)phen-1-yl]pyridinato}platin(II)

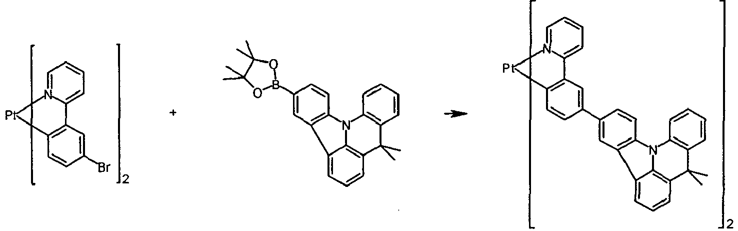

Bis-[(3-bromphen-1-yl)pyridinato]platin(II) kann wie in WO 2004/041835 beschrieben hergestellt werden. Bis-{1-[3-(8,8-dimethyl-8H-indolo[3,2,1-de]acridin-3-yl)phen-1-yl]pyridinato}platin(II) kann daraus analog zum unter F.1 beschriebenen Verfahren aus Bis-[(3-bromphen-1-yl)pyridinato]-platin(II) und 8,8-Dimethyl-8H-indolo[3,2,1-de]acridin-3-yl-boronsäure [1307793-50-5] hergestellt werden.

### H) Herstellung von Vergleichsbeispielen

### H.1) Herstellung der Vergleichsbeispiele V1 und V2

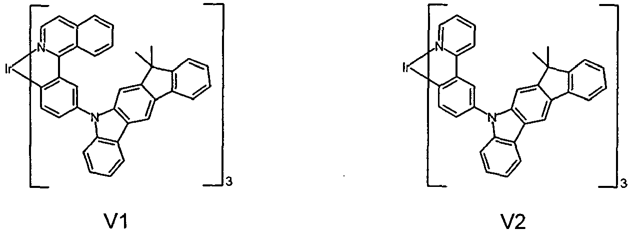

Die Vergleichsbeispiele V1 und V2 können gemäß WO 2011/141120 hergestellt werden.

### H.2) Herstellung der Vergleichsbeispiele V3 bis V6

Die Vergleichsbeispiele V3 bis V6 können analog zu den oben beschriebenen Verfahren hergestellt werden:

| **Bsp.** | **Edukt 1** | **Edukt 2** | **Produkt** | **Herstellung gemäß** |
|---|---|---|---|---|
| V3 | Ir(L1Br)₃ | 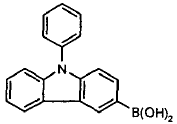 | 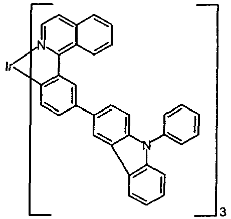 | F.1 |
| | | [854952-58-2] | | |
| V4 | Ir(L3Br)₃ | 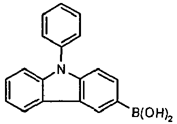 | 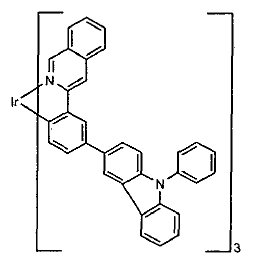 | F.2 |
| | | [854952-58-2] | | |
| V5 | Ir(L4Br)₃ | 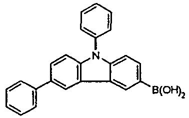 | 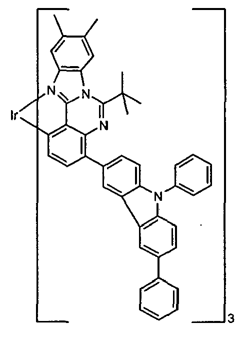 | F.4 |
| | | [1133058-06-6] | | |
| V6 | Ir(L5Br)₂(CL1) | 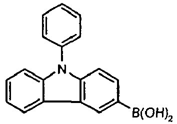 | 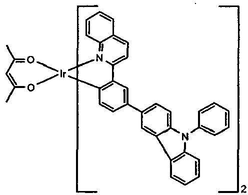 | F.5 |
| | | [854952-58-2] | | |
| V7 | Ir(L1Br)₃ | 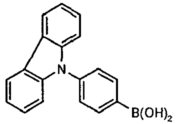 | 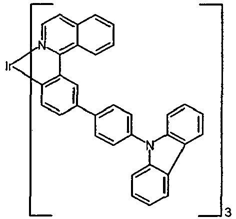 | F.1 |
| | | [419536-33-7] | | |

### Beispiel 1: Photolumineszenz in Lösung

Die erfindungsgemäßen Komplexe können in Toluol gelöst werden. Die Kenndaten von Photolumineszenzspektren toluolischer Lösungen der Komplexe aus Tabelle 1 sind in Tabelle 2 aufgeführt. Dabei wurden Lösungen mit einer Konzentration von etwa 1 mg/ml verwendet und die optische Anregung im lokalen Absorptionsmaximum durchgeführt (bei ca. 450 nm für rote Komplexe, ca. 380 nm für blaue Komplexe, ca. 410 nm für grüne Komplexe). Dabei zeigen erfindungsgemäße Komplexe eine schmalere Halbwertsbreite sowie ein rotverschobenes Spektrum.

**Tabelle 1: Strukturen in Photolumineszenz untersuchter erfindungsgemäßer Komplex sowie zugehöriger Vergleichskomplexe**

| | |
|---|---|
| 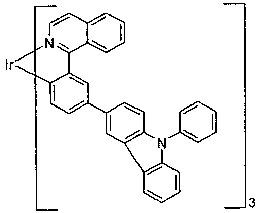 | 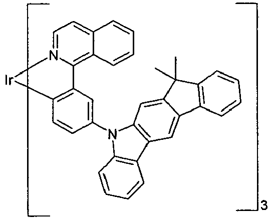 |
| V3 | V1 |
| 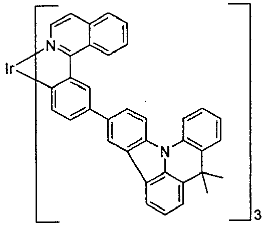 | 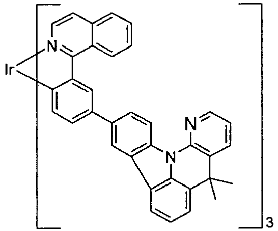 |
| K1 | K21 |
| 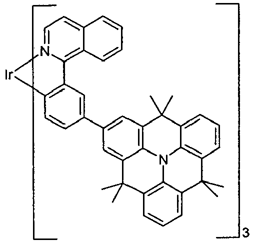 | 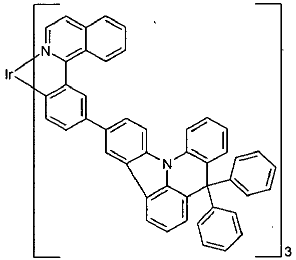 |
| K32 | K12 |
| 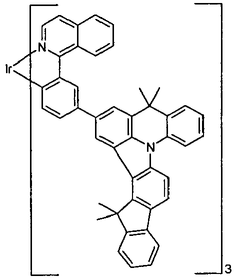 | 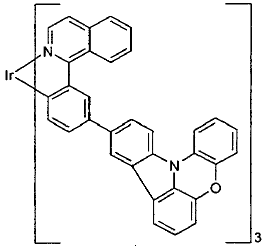 |
| K5 | K18 |
| 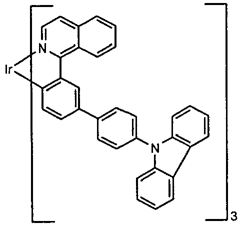 | 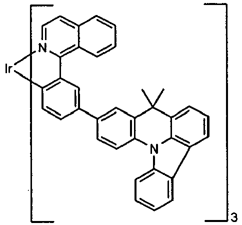 |
| V7 | K7 |
| 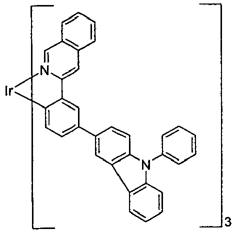 | 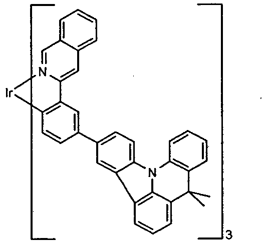 |
| V4 | K37 |
| 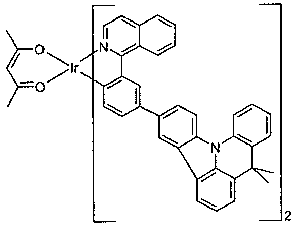 | 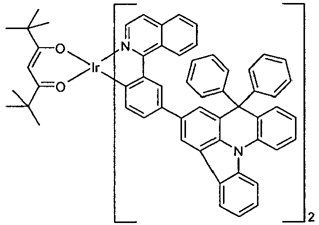 |
| K67 | K70 |
| 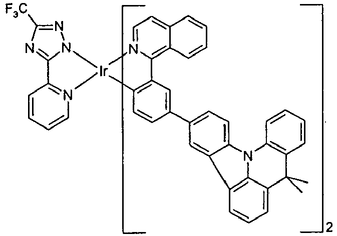 | 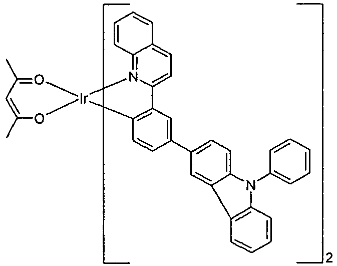 |
| K76 | V6 |
| 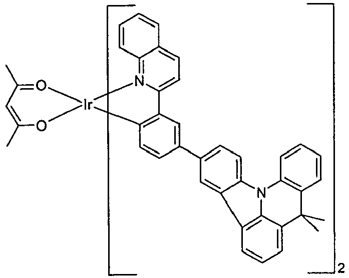 | 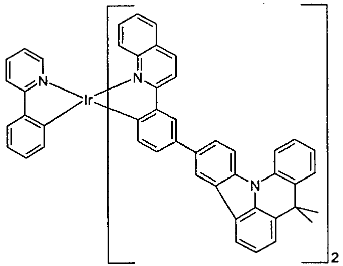 |
| K78 | K87 |
| 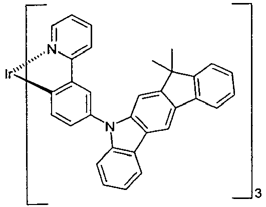 | 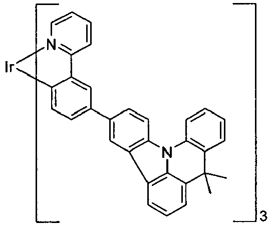 |
| V2 | K43 |
| 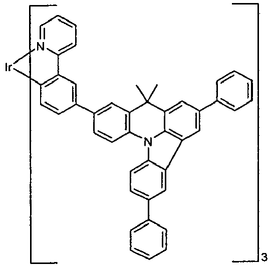 | 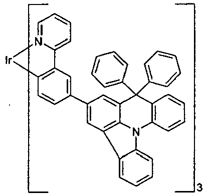 |
| K48 | K50 |
| 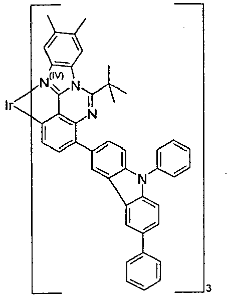 | 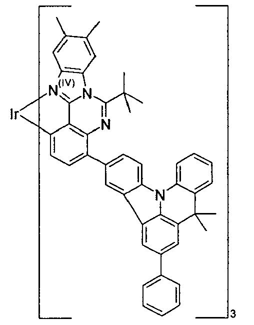 |
| V5 | K59 |

**Tabelle 2: Photolumineszenz-Kenndaten**

| | Emission max. (nm) | FWHM (nm) |
|---|---|---|
| V3 | 620 | 74 |
| V1 | 617 | 73 |
| K1 | 628 | 65 |
| K21 | 629 | 66 |
| K32 | 631 | 62 |
| K12 | 624 | 64 |
| K5 | 624 | 64 |
| K18 | 628 | 62 |
| V7 | 620 | 75 |
| K7 | 627 | 65 |
| V4 | 589 | 87 |
| K37 | 591 | 75 |
| K67 | 634 | 61 |
| K70 | 626 | 66 |
| K76 | 629 | 66 |
| V6 | 603 | 70 |
| K78 | 611 | 61 |
| K87 | 599 | 66 |
| V2 | 517 | 62 |
| K43 | 519 | 57 |
| K48 | 525 | 57 |
| K50 | 518 | 56 |
| V5 | 483 | 55 |
| K59 | 485 | 49 |

### Beispiel 2: Herstellung der OLEDs

Die erfindungsgemäßen Komplexe können aus Lösung verarbeitet werden und führen gegenüber vakuumprozessierten OLEDs zu einfacher herstellbaren OLEDs mit dennoch guten Eigenschaften. Die Herstellung vollständig lösungsbasierter OLEDs ist in der Literatur bereits vielfach beschrieben, z. B. in WO 2004/037887. Die Herstellung vakuumbasierter OLEDs ist ebenfalls vielfach vorbeschrieben, u.a. in WO 2004/058911.

In den im Folgenden diskutierten Beispielen wurden lösungsbasiert und vakuumbasiert aufgebrachte Schichten innerhalb einer OLED kombiniert, so dass die Prozessierung bis einschließlich zur Emissionsschicht aus Lösung und in den darauffolgenden Schichten (Lochblockierschicht und Elektronentransportschicht) aus dem Vakuum erfolgte. Die vorbeschriebenen allgemeinen Verfahren werden dafür wie folgt auf die hier beschriebenen Gegebenheiten (Schichtdickenvariation, Materialien) angepasst und kombiniert:
Der Aufbau ist wie folgt:
- Substrat,
- ITO (50 nm),
- PEDOT (80 nm bzw. 20 nm, angepasst für rote bzw. grüne Emissionsschichten),
- Interlayer (IL) (20 nm),
- Emissionsschicht (EML) (60 nm),
- Lochblockierschicht (HBL) (10 nm)
- Elektronentransportschicht (ETL) (40 nm),
- Kathode.

Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180°C für 10 Minuten ausgeheizt, um Restwasser zu entfernen. Auf diese beschichteten Glasplättchen werden die Interlayer sowie die Emissionsschicht aufgebracht. Die verwendete Interlayer dient der Lochinjektion und ist vernetzbar. Es wird ein Polymer der nachfolgend gezeigten Struktur verwendet, das gemäß WO 2010/097155 synthetisiert werden kann. Die Interlayer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt.

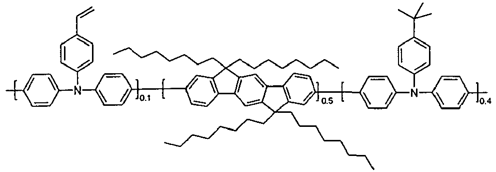

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol gelöst. Der typische Feststoffgehalt solcher Lösungen liegt bei ca. 18 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 180 °C ausgeheizt. Die im vorliegenden Fall verwendeten Materialien sind in Tabelle 3 gezeigt.

**Tabelle 3: Verwendete EML-Materialien**

| | | |
|---|---|---|
| 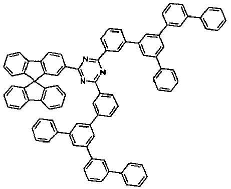 | 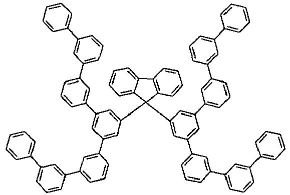 | 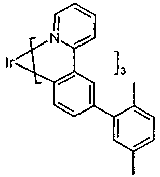 |
| TMM-A | TMM-B | Co-Dotand C |

Die Materialien für die Lochblockierschicht und Elektronentransportschicht werden in einer Vakuumkammer thermisch aufgedampft. Dabei kann z. B. die Elektronentransportschicht aus mehr als einem Material bestehen, die einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 4 gezeigt.

**Tabelle 4: Verwendete HBL- und ETL-Materialien**

| | |
|---|---|
| 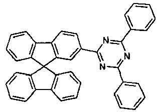 | 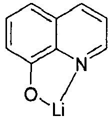 |
| ETM1 | ETM2 |

Die Kathode wird durch die thermische Verdampfung einer 100nm Aluminiumschicht gebildet. Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie die Betriebsspannung (in V) und die externe Quanteneffizienz (in %) bei einer bestimmten Helligkeit. Die Elektrolumineszenzspektren werden bei einer Leuchtdichte von 1000 cd/m² gemessen und daraus die CIE 1931 x und y Farbkoordinaten berechnet. LD80 @ 8000 cd/m² ist die Lebensdauer, bis die OLED bei einer Starthelligkeit von 8000 cd/m² auf 80 % der Anfangsintensität, also auf 6400 cd/m², abgefallen ist. Entsprechend ist LD80 @ 10000 cd/m² die Lebensdauer, bis die OLED bei einer Starthelligkeit von 10000 cd/m² auf 80 % der Anfangsintensität, also auf 8000 cd/m², abgefallen ist.

Die Daten von OLEDs, deren EML aus 50% TMM-A, 35% TMM-B, und 15 % Dotand D (gemäß Tabelle 1) bestehen, sind in Tabelle 5 gezeigt. Dabei wird ETM-1 als HBL und ETM1:ETM2 (50%:50%) als ETL verwendet. Es zeigt sich, dass erfindungsgemäße Komplexe nicht nur, wie bereits aus der Photolumineszenz erwartet, tiefere Farbkoordinaten aufweisen, sondern darüber hinaus auch eine erhöhte externe Quanteneffizienz bei vergleichbarer Lebensdauer.

**Tabelle 5: Ergebnisse lösungsprozessierter OLEDs mit EML-Mischungen vom Typ 50% TMM-A, 35% TMM-B, 15 % Dotand D**

| Dotand D | Effizienz bei 1000 cd/m² | Spannung bei 1000 cd/m² | CIE x/y bei 1000 cd/m² | | LD80 bei 8000 cd/m² |
|---|---|---|---|---|---|
| | % EQE | [V] | x | y | [h] |
| V1 | 11.7 | 6.3 | 0.669 | 0.329 | 19 |
| K1 | 13.4 | 7 | 0.689 | 0.310 | 17 |
| K21 | 13.6 | 7.1 | 0.689 | 0.310 | 19 |
| K32 | 13.5 | 6.8 | 0.693 | 0.306 | 22 |
| K12 | 13.1 | 6.9 | 0.685 | 0.314 | 19 |
| K5 | 13.2 | 6.7 | 0.685 | 0.314 | 21 |
| K18 | 13 | 6.7 | 0.691 | 0.308 | 16 |
| V7 | 11.6 | 6.4 | 0.675 | 0.321 | 18 |
| K7 | 13.4 | 6.9 | 0.688 | 0.311 | 18 |
| K67 | 13.5 | 7.3 | 0.692 | 0.307 | 8 |
| K70 | 13.3 | 7 | 0.686 | 0.313 | 9 |
| K76 | 13.1 | 7 | 0.689 | 0.309 | 9 |
| V6 | 14.8 | 6.4 | 0.655 | 0.343 | 12 |
| K78 | 15.1 | 6.7 | 0.675 | 0.324 | 10 |
| K87 | 15.0 | 6.6 | 0.626 | 0.372 | 17 |

Die Daten von OLEDs, deren EML aus 30% TMM-A, 34% TMM-B, 30% Co-Dotand C und 6 % Dotand D (gemäß Tabelle 1) bestehen, sind in Tabelle 6 gezeigt. Dabei wird ETM-1 als HBL und ETM1:ETM2 (50%:50%) als ETL verwendet. Es zeigt sich, dass erfindungsgemäße Komplexe generell tiefere Farbkoordinaten und höhere externe Quanteneffizienzen aufweisen als die entsprechenden Referenz-Komplexe.

**Tabelle 6: Ergebnisse lösungsprozessierter OLEDs mit EML-Mischungen vom Typ 30% TMM-A, 34% TMM-B, 30% Co-Dotand C, 6 % Dotand D**

| Dotand D | Effizienz bei 1000 cd/m² | Spannung bei 1000 cd/m² | CIE x/y bei 1000 cd/m² | | LD80 bei 8000 cd/m² |
|---|---|---|---|---|---|
| | % EQE | M | x | y | [h] |
| V1 | 11.4 | 6 | 0.649 | 0.348 | 165 |
| K1 | 11.8 | 6.8 | 0.676 | 0.323 | 131 |
| K21 | 12.1 | 6.7 | 0.676 | 0.321 | 149 |
| K12 | 11.7 | 6.7 | 0.672 | 0.325 | 155 |
| K5 | 11.8 | 6.5 | 0.672 | 0.325 | 116 |
| K18 | 11.6 | 6.6 | 0.677 | 0.320 | 90 |
| K67 | 11.9 | 6.9 | 0.679 | 0.319 | 37 |
| K70 | 11.6 | 6.6 | 0.674 | 0.324 | 42 |
| K76 | 11.8 | 6.7 | 0.676 | 0.321 | 63 |
| V6 | 12.9 | 6.3 | 0.635 | 0.362 | 55 |
| K78 | 13.3 | 6.4 | 0.655 | 0.343 | 57 |

Die Daten von OLEDs, deren EML aus 20% TMM-A, 50% TMM-B, und 30% Dotand D (gemäß Tabelle 1) bestehen, sind in Tabelle 7 gezeigt. Dabei wird ETM-1 als HBL und ETM1:ETM2 (50%:50%) als ETL verwendet. Es zeigt sich, dass der erfindungsgemäße Komplex höhere externe Quanteneffizienzen aufweist als der Referenz-Komplex.

**Tabelle 7: Ergebnisse lösungsprozessierter OLEDs mit EML-Mischungen vom Typ 20% TMM-A, 50% TMM-B, 30 % Dotand D**

| Dotand D | Effizienz bei 1000 cd/m² | Spannung bei 1000 cd/m² | CIE x/y bei 1000 cd/m² | | LD80 bei 8000 cd/m² |
|---|---|---|---|---|---|
| | % EQE | [V] | x | y | [h] |
| V2 | 17.9 | 4.9 | 0.313 | 0.639 | 128 |
| K43 | 19.1 | 5.2 | 0.322 | 0.630 | 142 |

## Patentansprüche

1. Verbindung gemäß Formel (1),
M(L)ₙ(L')ₘ Formel (1)
wobei die Verbindung der allgemeinen Formel (1) eine Teilstruktur M(L)ₙ der Formel (2) oder Formel (3) enthält: 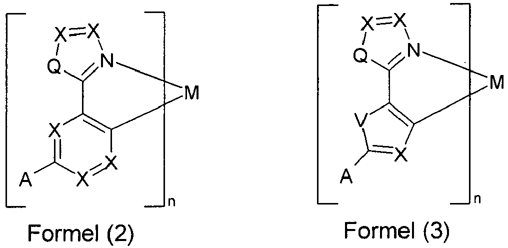 wobei A gleich oder verschieden bei jedem Auftreten eine Gruppe der folgenden Formel (A) darstellt: 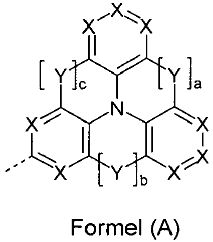 wobei die gestrichelte Bindung in Formel (A) die Position der Verknüpfung dieser Gruppe darstellt und für die weiteren verwendeten Symbole und Indizes gilt:
M ist ein Metall ausgewählt aus der Gruppe bestehend aus Iridium, Rhodium, Platin und Palladium;
X ist gleich oder verschieden bei jedem Auftreten CR¹ oder N;
Q ist gleich oder verschieden bei jedem Auftreten R¹C=CR¹, R¹C=N, O, S, Se oder NR¹;
V ist gleich oder verschieden bei jedem Auftreten O, S, Se oder NR¹;
Y ist gleich oder verschieden bei jedem Auftreten eine Einfachbindung oder eine bivalente Gruppe ausgewählt aus C(R¹)₂, C(=O), O, S, NR¹ oder BR¹;
R¹ ist gleich oder verschieden bei jedem Auftreten H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination aus zwei oder mehr dieser Gruppen; dabei können zwei oder mehr Reste R¹ auch miteinander ein mono- oder polycyclisches, aliphatisches, aromatisches und/oder benzoannelliertes Ringsystem bilden;
R² ist gleich oder verschieden bei jedem Auftreten H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination aus zwei oder mehr dieser Gruppen; dabei können zwei oder mehrere benachbarte Reste R² miteinander ein mono- oder polycyclisches, aliphatisches, aromatisches und/oder benzoannelliertes Ringsystem bilden;
R³ ist gleich oder verschieden bei jedem Auftreten H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches, aromatisches und/oder benzoannelliertes Ringsystem bilden;
L' ist gleich oder verschieden bei jedem Auftreten ein Coligand;
n ist 1, 2 oder 3 für M gleich Iridium oder Rhodium und ist 1 oder 2 für M gleich Platin oder Palladium;
m ist 0, 1, 2, 3 oder 4;
a, b, c ist gleich oder verschieden bei jedem Auftreten 0 oder 1, wobei a = 0 bzw. b = 0 bzw. c = 0 bedeutet, dass die jeweilige Gruppe Y nicht vorhanden ist und statt dessen an die entsprechenden Kohlenstoffatome jeweils ein Rest R¹ gebunden ist; mit der Maßgabe, dass a + b + c ≥ 2 ist;
dabei können auch mehrere Liganden L miteinander oder L mit L' über eine beliebige Brücke Z verknüpft sein und so ein tridentates, tetradentates, pentadentates oder hexadentates Ligandensystem aufspannen.

2. Verbindung nach Anspruch 1, **dadurch gekennzeichnet, dass** kein oder ein Symbol X pro Cyclus für N und die anderen Symbole X für CR¹ stehen.

3. Verbindung nach Anspruch 1 oder 2, **dadurch gekennzeichnet, dass** in der Gruppe der Formel (A) zwei der Indizes a, b und c = 1 und der dritte Index = 0 ist.

4. Verbindung nach einem oder mehreren der Ansprüche 1 bis 3,
**dadurch gekennzeichnet, dass** die Gruppe A gleich oder verschieden bei jedem Auftreten ausgewählt ist aus den Gruppen der Formeln (A-1), (A-2) und (A-3), 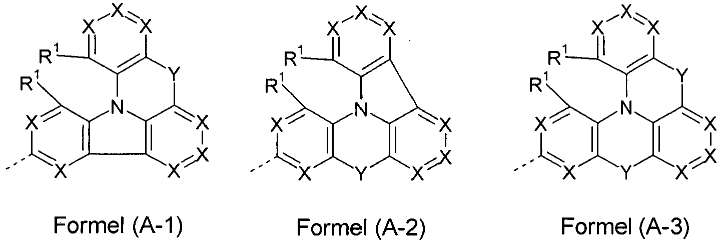 wobei Y für C(R¹)₂, NR¹, O oder S steht, X bevorzugt für CR¹ steht und die weiteren verwendeten Symbole die in Anspruch 1 genannten Bedeutungen aufweisen.

5. Verbindung nach einem oder mehreren der Ansprüche 1 bis 4,
**dadurch gekennzeichnet, dass** die Gruppe A gleich oder verschieden bei jedem Auftreten ausgewählt ist aus den Gruppen der Formeln (A-1b), (A-2b) und (A-3b), 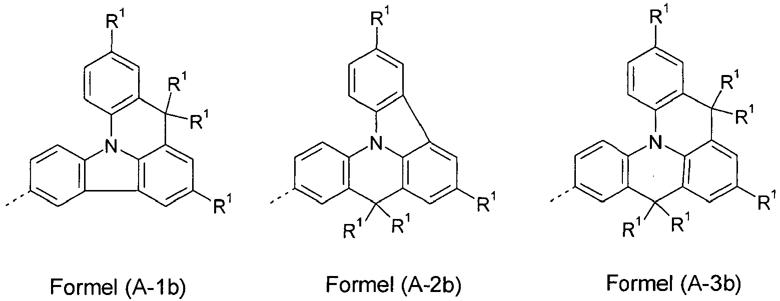 wobei die verwendeten Symbole die in Anspruch 1 genannten Bedeutungen aufweisen.

6. Verbindung nach einem oder mehreren der Ansprüche 1 bis 5,
**dadurch gekennzeichnet, dass** für die verwendeten Symbole und Indizes gilt:
M ist Iridium oder Platin;
A ist gleich oder verschieden bei jedem Auftreten eine Gruppe der Formel (A-1) bzw. (A-2) bzw. (A-3) gemäß Anspruch 4;
X ist gleich oder verschieden bei jedem Auftreten CR¹;
Q ist gleich oder verschieden bei jedem Auftreten R¹C=CR¹ oder R¹C=N;
V ist gleich oder verschieden bei jedem Auftreten O, S oder NR¹;
Y ist gleich oder verschieden bei jedem Auftreten C(R¹)₂, NR¹ oder O.

7. Verbindung nach einem oder mehreren der Ansprüche 1 bis 6,
**dadurch gekennzeichnet, dass** für die verwendeten Symbole und Indizes gilt:
M ist Iridium;
A ist gleich oder verschieden bei jedem Auftreten eine Gruppe der Formel (A-1b) bzw. (A-2b) bzw. (A-3b) gemäß Anspruch 5;
X ist gleich oder verschieden bei jedem Auftreten CR¹;
Q ist gleich oder verschieden bei jedem Auftreten R¹C=CR1;
V ist S;
Y ist gleich oder verschieden bei jedem Auftreten C(R¹)₂, NR¹ oder O.

8. Verbindung nach einem oder mehreren der Ansprüche 1 bis 7,
**dadurch gekennzeichnet, dass** die Teilstrukturen der Formel (2) oder (3) ausgewählt sind aus den Teilstrukturen der Formeln (4-1), (4-2), (4-3), (4-4), (5-1), (5-2) und (5-3), 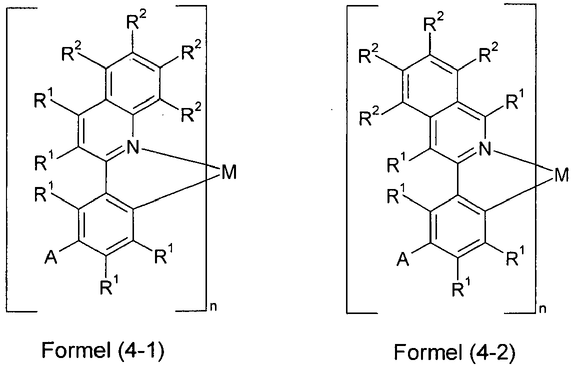 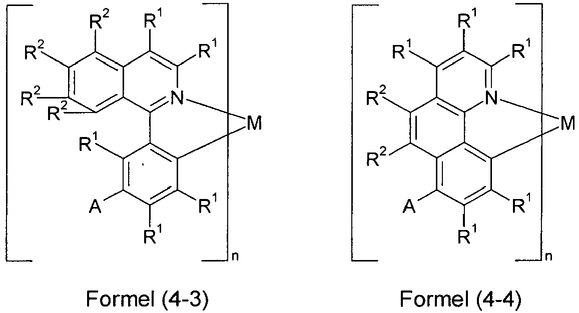 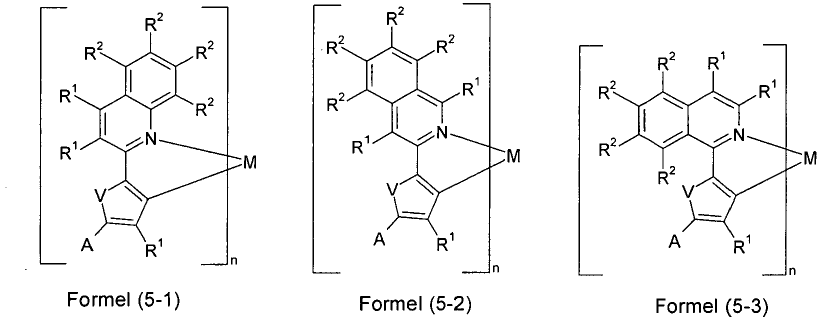 wobei die verwendeten Symbole und Indizes die in Anspruch 1 genannten Bedeutungen aufweisen.

9. Verbindung nach einem oder mehreren der Ansprüche 1 bis 8,
**dadurch gekennzeichnet, dass** statt einem der Reste R¹ eine verbrückende Einheit Z vorhanden sein, und die Verbindungen ausgewählt sind aus den Formeln (6) bis (9), 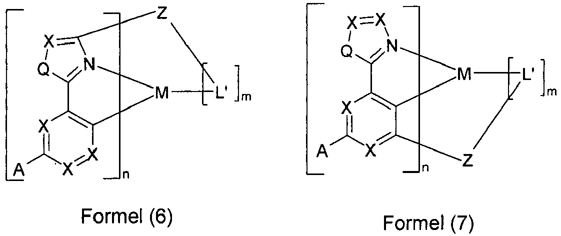 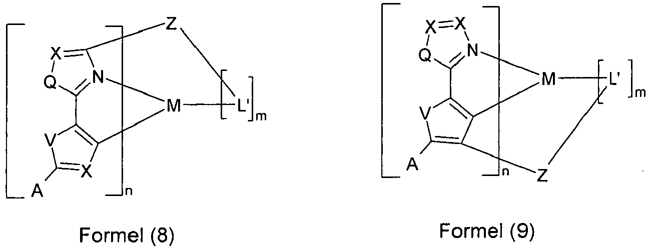 wobei die verwendeten Symbole die in Anspruch 1 genannten Bedeutungen aufweisen und Z eine verbrückende Einheit darstellt, enthaltend 1 bis 80 Atome aus der dritten, vierten, fünften und/oder sechsten Hauptgruppe oder einen 3- bis 6-gliedrigen Homo- oder Heterocyclus, die die Teilliganden L miteinander oder L mit L' miteinander kovalent verbindet.

10. Verbindung nach einem oder mehreren der Ansprüche 1 bis 9,
**dadurch gekennzeichnet, dass** L' ausgewählt ist aus der Gruppe bestehend aus Kohlenmonoxid, Stickstoffmonoxid, Alkylcyaniden, Arylcyaniden, Alkylisocyaniden, Arylisocyaniden, Aminen, Phosphinen, Phosphiten, Arsinen, Stibinen, stickstoffhaltigen Heterocyclen, Carbenen, Hydrid, Deuterid, den Halogeniden F⁻, Cl⁻, Br⁻ und I⁻, Alkyl- oder Arylacetyliden, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten, Arylgruppen, O²⁻, S²⁻, Carbiden, Nitrenen, Diaminen, Iminen, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten, Dithiolaten, Boraten stickstoffhaltiger Heterocyclen und bidentaten monoanionischen Liganden, welche mit dem Metall einen cyclometallierten Fünfring oder Sechsring mit mindestens einer Metall-Kohlenstoff-Bindung aufweisen.

11. Verfahren zur Herstellung einer Verbindung nach einem oder mehreren der Ansprüche 1 bis 10 umfassend die Umsetzung der entsprechenden freien Liganden mit Metallalkoholaten der Formel (55), mit Metallketoketonaten der Formel (56), mit Metallhalogeniden der Formel (57), mit dimeren Metallkomplexen der Formel (58) oder mit Metallverbindungen, die sowohl Alkoholat- und/oder Halogenid- und/oder Hydroxy- wie auch Ketoketonatreste tragen, 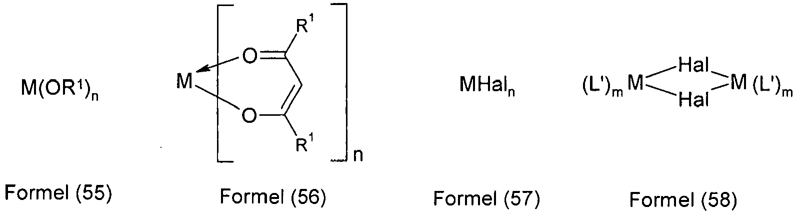 wobei die Symbole M, m, n und R¹ die in Anspruch 1 angegebenen Bedeutungen haben und Hal = F, Cl, Br oder I ist.

12. Formulierung, enthaltend mindestens eine Verbindung nach einem oder mehreren der Ansprüche 1 bis 10 und mindestens ein Lösemittel.

13. Verwendung einer Verbindung nach einem oder mehreren der Ansprüche 1 bis 10 oder einer Formulierung nach Anspruch 12 in einer elektronischen Vorrichtung oder zur Erzeugung von Singulett-Sauerstoff, in der Photokatalyse oder in Sauerstoffsensoren.

14. Elektronische Vorrichtung enthaltend mindestens eine Verbindung nach einem oder mehreren der Ansprüche 1 bis 10, bevorzugt ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 10 als emittierende Verbindung in einer oder mehreren emittierenden Schichten eingesetzt wird, optional in Kombination mit einem Matrixmaterial.

## Claims

1. Compound of the formula (1),
M(L)ₙ(L')ₘ formula (1)
where the compound of the general formula (1) contains a moiety M(L)ₙ of the formula (2) or formula (3): 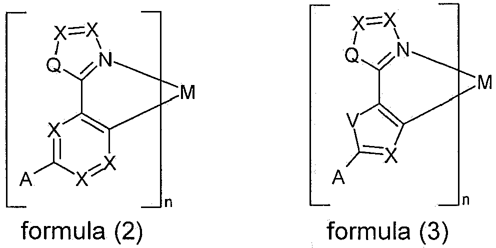 where A represents, identically or differently on each occurrence, a group of the following formula (A): 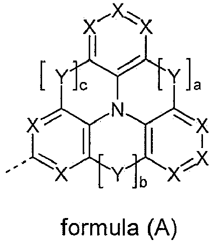 where the dashed bond in formula (A) represents the position of the linking of this group, and the following applies to the other symbols and indices used:
M is a metal selected from the group consisting of iridium, rhodium, platinum and palladium;
X is, identically or differently on each occurrence, CR¹ or N;
Q is, identically or differently on each occurrence, R¹C=CR¹, R¹C=N, O, S, Se or NR¹;
V is, identically or differently on each occurrence, O, S, Se or NR¹;
Y is, identically or differently on each occurrence, a single bond or a divalent group selected from C(R¹)₂, C(=O), O, S, NR¹ or BR¹;
R¹ is, identically or differently on each occurrence, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R², where one or more non-adjacent CH₂ groups may be replaced by R²C=CR², C≡C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², or a diarylamino group, diheteroarylamino group or arylheteroarylamino group having 10 to 40 aromatic ring atoms, which may be substituted by one or more radicals R², or a combination of two or more of these groups; two or more radicals R¹ may also form a mono- or polycyclic, aliphatic, aromatic and/or benzo-fused ring system with one another;
R² is, identically or differently on each occurrence, H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R³, where one or more non-adjacent CH₂ groups may be replaced by R³C=CR³, C≡C, Si(R³)₂, Ge(R³)₂, Sn(R³)₂, C=O, C=S, C=Se, C=NR³, P(=O)(R³), SO, SO₂, NR³, O, S or CONR³ and where one or more H atoms may be replaced by D, F, Cl, Br, I, CN or NO₂, or an aromatic or heteroaromatic ring system having 5 to 60 aromatic ring atoms, which may in each case be substituted by one or more radicals R³, or an aryloxy or heteroaryloxy group having 5 to 60 aromatic ring atoms, which may be substituted by one or more radicals R³, or a diarylamino group, diheteroarylamino group or arylheteroarylamino group having 10 to 40 aromatic ring atoms, which may be substituted by one or more radicals R³, or a combination of two or more of these groups; two or more adjacent radicals R² may also form a mono- or polycyclic, aliphatic, aromatic and/or benzo-fused ring system with one another;
R³ is, identically or differently on each occurrence, H, D, F or an aliphatic, aromatic and/or heteroaromatic hydrocarbon radical having 1 to 20 C atoms, in which, in addition, one or more H atoms may be replaced by F; two or more substituents R³ may also form a mono- or polycyclic, aliphatic, aromatic and/or benzo-fused ring system with one another;
L' is, identically or differently on each occurrence, a co-ligand;
n is 1, 2 or 3 for M equal to iridium or rhodium and is 1 or 2 for M equal to platinum or palladium;
m is 0, 1, 2, 3 or 4;
a, b, c are, identically or differently on each occurrence, 0 or 1, where a = 0 or b = 0 or c = 0 means that the respective group Y is not present and instead a radical R¹ is in each case bonded to the corresponding carbon atoms; with the proviso that a + b + c ≥ 2; a plurality of ligands L may also be linked to one another or L may be linked to L' via any desired bridge Z and thus form a tridentate, tetradentate, pentadentate or hexadentate ligand system.

2. Compound according to Claim 1, **characterised in that** no or one symbol X per ring stands for N and the other symbols X stand for CR¹.

3. Compound according to Claim 1 or 2, **characterised in that**, in the group of the formula (A), two of the indices a, b and c = 1 and the third index = 0.

4. Compound according to one or more of Claims 1 to 3, **characterised in that** the group A is selected, identically or differently on each occurrence, from the groups of the formulae (A-1), (A-2) and (A-3), 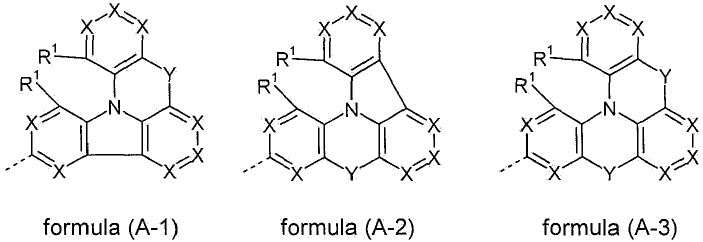 where Y stands for C(R¹)₂, NR¹, O or S, X preferably for CR¹, and the other symbols used have the meanings given in Claim 1.

5. Compound according to one or more of Claims 1 to 4, **characterised in that** the group A is selected, identically or differently on each occurrence, from the groups of the formulae (A-1b), (A-2b) and (A-3b), 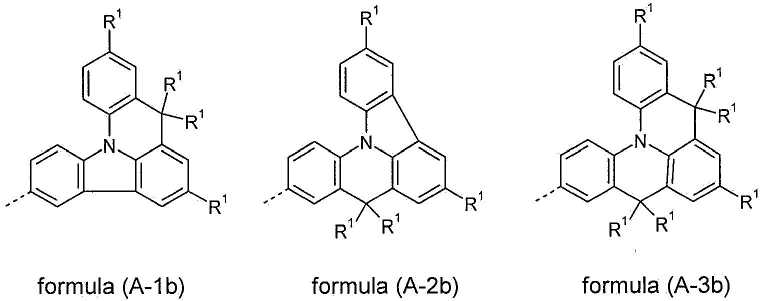 where the symbols used have the meanings given in Claim 1.

6. Compound according to one or more of Claims 1 to 5, **characterised in that** the following applies to the symbols and indices used:
M is iridium or platinum;
A is, identically or differently on each occurrence, a group of the formula (A-1) or (A-2) or (A-3) according to Claim 4;
X is, identically or differently on each occurrence, CR¹;
Q is, identically or differently on each occurrence, R¹C=CR¹ or R¹C=N;
V is, identically or differently on each occurrence, O, S or NR¹;
Y is, identically or differently on each occurrence, C(R¹)₂, NR¹ or O.

7. Compound according to one or more of Claims 1 to 6, **characterised in that** the following applies to the symbols and indices used:
M is iridium;
A is, identically or differently on each occurrence, a group of the formula (A-1b) or (A-2b) or (A-3b) according to Claim 5;
X is, identically or differently on each occurrence, CR¹;
Q is, identically or differently on each occurrence, R¹C=CR¹;
V is S;
Y is, identically or differently on each occurrence, C(R¹)₂, NR¹ or O.

8. Compound according to one or more of Claims 1 to 7, **characterised in that** the moieties of the formula (2) or (3) are selected from the moieties of the formulae (4-1), (4-2), (4-3), (4-4), (5-1), (5-2) and (5-3), 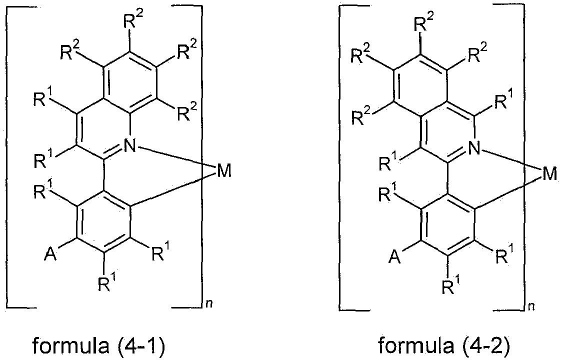 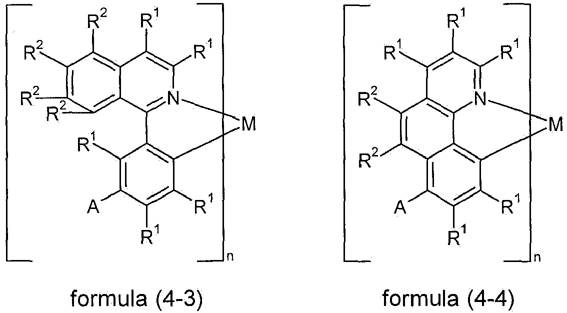 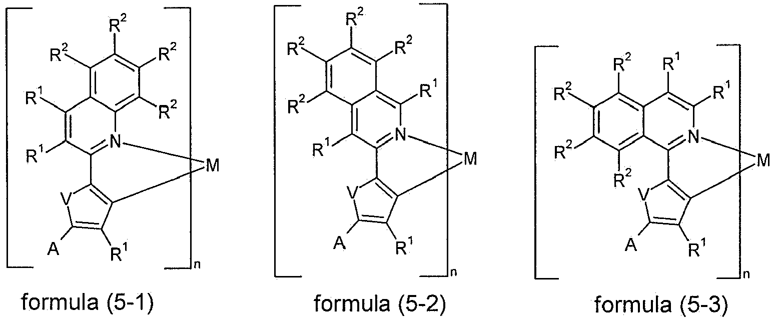 where the symbols and indices used have the meanings given in Claim 1.

9. Compound according to one or more of Claims 1 to 8, **characterised in that** a bridging unit V is present instead of one of the radicals R¹, and the compounds are selected from the formulae (6) to (9), 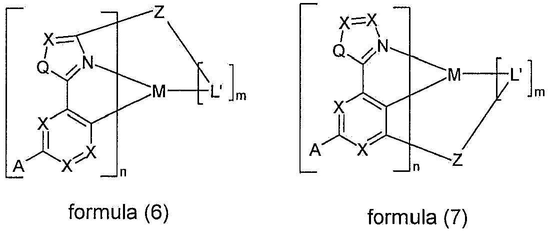 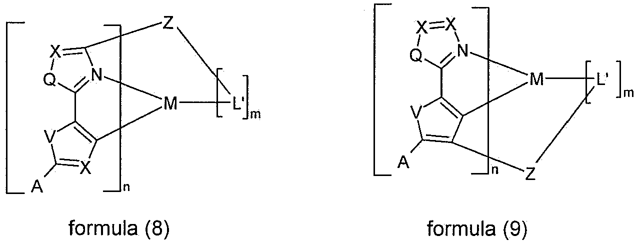 where the symbols used have the meanings given in Claim 1 and Z represents a bridging unit containing 1 to 80 atoms from the third, fourth, fifth and/or sixth main group or a 3- to 6-membered homo- or heterocycle which covalently bonds the part-ligands L to one another or to L'.

10. Compound according to one or more of Claims 1 to 9, **characterised in that** L' is selected from the group consisting of carbon monoxide, nitrogen monoxide, alkyl cyanides, aryl cyanides, alkyl isocyanides, aryl isocyanides, amines, phosphines, phosphites, arsines, stibines, nitrogen-containing heterocycles, carbenes, hydride, deuteride, the halides F⁻, Cl⁻, Br⁻ and I⁻, alkyl- or arylacetylides, cyanide, cyanate, isocyanate, thiocyanate, isothiocyanate, aliphatic or aromatic alcoholates, aliphatic or aromatic thioalcoholates, amides, carboxylates, aryl groups, O²⁻, S²⁻, carbides, nitrenes, diamines, imines, diphosphines, 1,3-diketonates derived from 1,3-diketones, 3-ketonates derived from 3-ketoesters, carboxylates derived from aminocarboxylic acids, salicyl-iminates derived from salicylimines, dialcoholates, dithiolates, borates of nitrogen-containing heterocycles and bidentate monoanionic ligands, which, with the metal, form a cyclometallated five-membered ring or six-membered ring having at least one metal-carbon bond

11. Process for the preparation of a compound according to one or more of Claims 1 to 10 comprising the reaction of the corresponding free ligands with metal alcoholates of the formula (55), with metal keto-ketonates of the formula (56), with metal halides of the formula (57), with dimeric metal complexes the formula (58) or with metal compounds which carry both alcoholate and/or halide and/or hydroxyl radicals and also ketoketonate radicals, 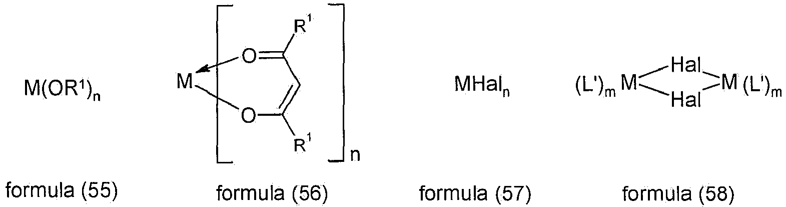 where the symbols M, m, n and R¹ have the meanings indicated in Claim 1 and Hal = F, Cl, Br or I.

12. Formulation comprising at least one compound according to one or more of Claims 1 to 10 and at least one solvent.

13. Use of a compound according to one or more of Claims 1 to 10 or a formulation according to Claim 12 in an electronic device or for the generation of singlet oxygen, in photocatalysis or in oxygen sensors.

14. Electronic device containing at least one compound according to one or more of Claims 1 to 10, preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

15. Electronic device according to Claim 14, which is an organic electroluminescent device, **characterised in that** the compound according to one or more of Claims 1 to 10 is employed as emitting compound in one or more emitting layers, optionally in combination with a matrix material.

## Revendications

1. Composé de la formule (1) :
M(L)ₙ(L')ₘ formule (1)
dans laquelle le composé de la formule générale (1) contient une moitié M(L)ₙ de la formule (2) ou de la formule (3) : 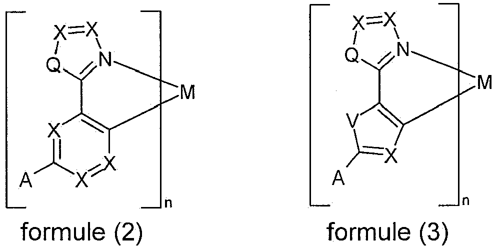 dans lesquelles A représente, de manière identique ou différente pour chaque occurrence, un groupe de la formule (A) qui suit : 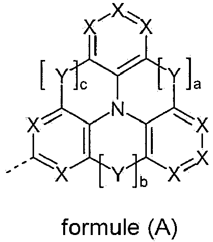 dans laquelle le lien en pointillés dans la formule (A) représente la position de la liaison de ce groupe, et ce qui suit s'applique aux autres symboles et indices qui sont utilisés :
M est un métal qui est sélectionné parmi le groupe qui est constitué par l'iridium, le rhodium, le platine et le palladium ;
X est, de manière identique ou différente pour chaque occurrence, CR¹ ou N ;
Q est, de manière identique ou différente pour chaque occurrence, R¹C=CR¹, R¹C=N, O, S, Se ou NR¹ ;
V est, de manière identique ou différente pour chaque occurrence, O, S, Se ou NR¹ ;
Y est, de manière identique ou différente pour chaque occurrence, une liaison simple ou un groupe divalent qui est sélectionné parmi C(R¹)₂, C(=O), O, S, NR¹ ou BR¹ ;
R¹ est, de manière identique ou différente pour chaque occurrence, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C=C, Si(R²)₂, Ge(R²)₂, Sn(R²)₂, C=O, C=S, C=Se, C=NR², P(=)(R²), SO, SO₂, NR², O, S ou CONR² et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 60 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R², ou une combinaison de deux ou plus de ces groupes ; deux radicaux R¹ ou plus peuvent également former un système de cycle mono- ou polycyclique, aliphatique, aromatique et/ou benzofusionné l'un avec l'autre ou les uns avec les autres ;
R² est, de manière identique ou différente pour chaque occurrence, H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R³, où un ou plusieurs groupe(s) CH₂ non adjacents peut/peuvent être remplacé(s) par R³C=CR³, C≡C, Si(R³)₂, Ge(R³)₂, Sn(R³)₂, C=O, C=S, C=Se, C=NR³, P(=O)(R³), SO, SO₂, NR³, O, S ou CONR³ et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R³, ou un groupe aryloxy ou hétéroaryloxy qui comporte de 5 à 60 atomes de cycle aromatique, lequel peut être substitué par un radical ou par plusieurs radicaux R³, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R³, ou une combinaison de deux ou plus de ces groupes ; deux radicaux R² adjacents ou plus peuvent également former un système de cycle mono- ou polycyclique, aliphatique, aromatique et/ou benzo-fusionné l'un avec l'autre ou les uns avec les autres ;
R³ est, de manière identique ou différente pour chaque occurrence, H, D, F ou un radical hydrocarbone aliphatique, aromatique et/ou hétéroaromatique qui comporte de 1 à 20 atome(s) de C, où, en outre, un ou plusieurs atome(s) de H peut/peuvent être remplacé(s) par F ; deux substituants R³ ou plus peuvent également former un système de cycle mono- ou polycyclique, aliphatique, aromatique et/ou benzo-fusionné l'un avec l'autre ou les uns avec les autres ;
L' est, de manière identique ou différente pour chaque occurrence, un co-ligand ;
n est 1, 2 ou 3 for M égal à iridium ou rhodium et est 1 ou 2 pour M égal à platine ou palladium ;
m est 0, 1, 2, 3 ou 4 ;
a, b, c sont, de manière identique ou différente pour chaque occurrence, 0 ou 1, où a = 0 ou b = 0 ou c = 0 signifie que le groupe respectif Y n'est pas présent et qu'en lieu et place, un radical R¹ est dans chaque cas lié sur les atomes de carbone correspondants ; étant entendu que a + b + c ≥ 2 ;
une pluralité de ligands L peuvent également être liés les uns aux autres ou L peut être lié à L' via un quelconque pont souhaité Z et peuvent ainsi former un système de ligands tridenté, tétradenté, pentadenté ou hexadenté.

2. Composé selon la revendication 1, **caractérisé en ce qu'**aucun symbole ou un seul symbole X par cycle ne représente/représente N et **en ce que** les autres symboles X représentent CR¹.

3. Composé selon la revendication 1 ou 2, **caractérisé en ce que**, dans le groupe de la formule (A), deux des indices a, b et c = 1 et le troisième indice = 0.

4. Composé selon une ou plusieurs des revendications 1 à 3, **caractérisé en ce que** le groupe A est sélectionné, de manière identique ou différente pour chaque occurrence, parmi les groupes des formules (A-1), (A-2) et (A-3) : 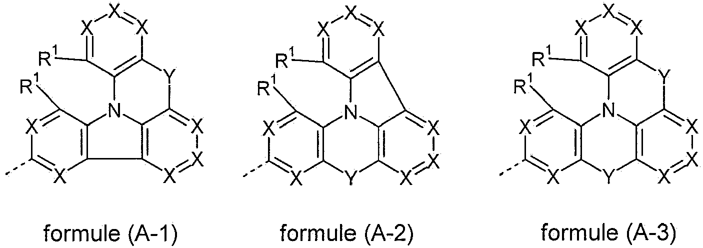 dans lesquelles Y représente C(R¹)₂, NR¹, O ou S, X représente de préférence CR¹, et les autres symboles qui sont utilisés présentent les significations qui ont été données selon la revendication 1.

5. Composé selon une ou plusieurs des revendications 1 à 4, **caractérisé en ce que** le groupe A est sélectionné, de manière identique ou différente pour chaque occurrence, parmi les groupes des formules (A-1b), (A-2b) et (A-3b) : 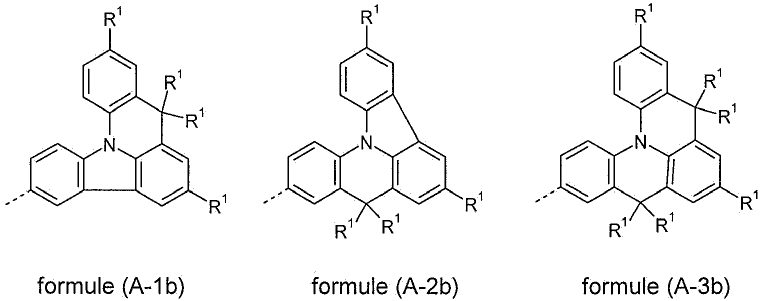 dans lesquelles les symboles qui sont utilisés présentent les significations qui ont été données selon la revendication 1.

6. Composé selon une ou plusieurs des revendications 1 à 5, **caractérisé en ce que** ce qui suit s'applique aux symboles et aux indices qui sont utilisés :
M est iridium ou platine ;
A est, de manière identique ou différente pour chaque occurrence, un groupe de la formule (A-1) ou (A-2) ou (A-3) selon la revendication 4 ;
X est, de manière identique ou différente pour chaque occurrence, CR¹ ;
Q est, de manière identique ou différente pour chaque occurrence, R¹C=CR¹ ou R¹C=N ;
V est, de manière identique ou différente pour chaque occurrence, O, S ou NR¹ ;
Y est, de manière identique ou différente pour chaque occurrence, C(R¹)₂, NR¹ ou O.

7. Composé selon une ou plusieurs des revendications 1 à 6, **caractérisé en ce que** ce qui suit s'applique aux symboles et aux indices qui sont utilisés :
M est iridium ;
A est, de manière identique ou différente pour chaque occurrence, un groupe de la formule (A-1b) ou (A-2b) ou (A-3b) selon la revendication 5 ;
X est, de manière identique ou différente pour chaque occurrence, CR¹ ;
Q est, de manière identique ou différente pour chaque occurrence, R¹C=CR¹ ;
V est S ;
Y est, de manière identique ou différente pour chaque occurrence, C(R¹)₂, NR¹ ou O.

8. Composé selon une ou plusieurs des revendications 1 à 7, **caractérisé en ce que** les moitiés de la formule (2) ou (3) sont sélectionnées parmi les moitiés des formules (4-1), (4-2), (4-3), (4-4), (5-1), (5-2) et (5-3) : 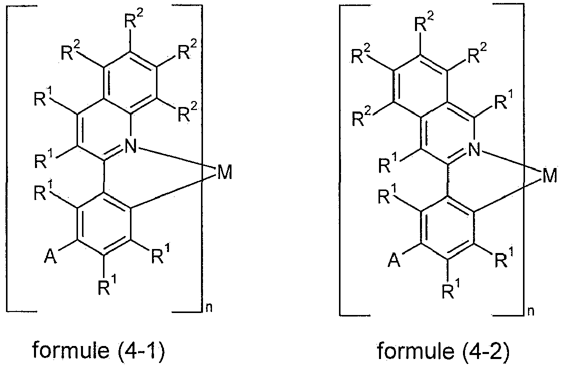 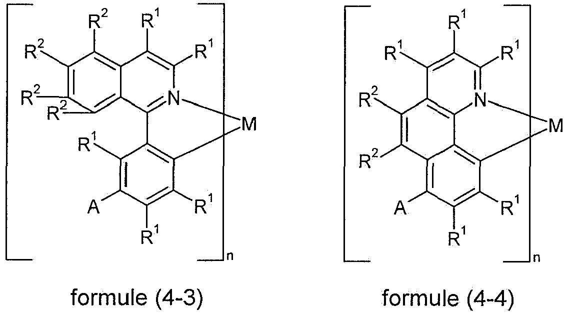 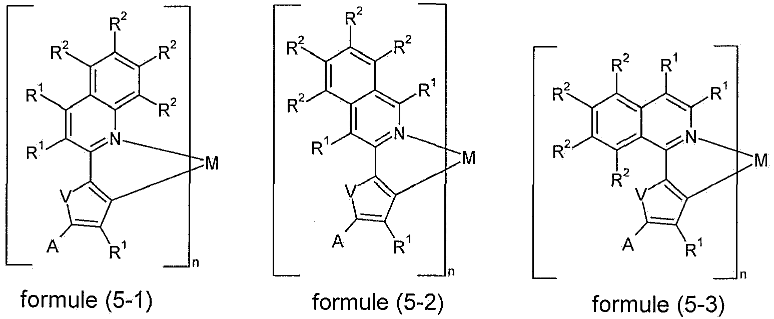 dans lesquelles les symboles et les indices qui sont utilisés présentent les significations qui ont été données selon la revendication 1.

9. Composé selon une ou plusieurs des revendications 1 à 8, **caractérisé en ce qu'**une unité de pontage V est présente en lieu et place de l'un des radicaux R¹, et les composés sont sélectionnés parmi les formules (6) à (9) : 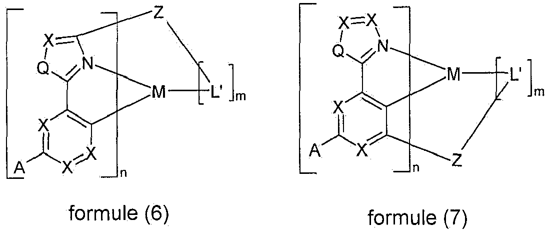 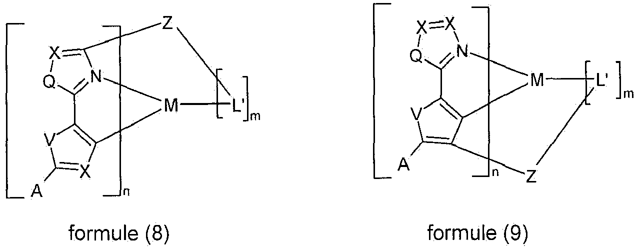 dans lesquelles les symboles qui sont utilisés présentent les significations qui ont été données selon la revendication 1 et Z représente une unité de pontage qui contient de 1 à 80 atome(s) pris à partir des troisième, quatrième, cinquième et/ou sixième groupes principaux ou un homo- ou hétérocycle à 3 à 6 éléments qui lie de façon covalente les ligands partiels L les uns aux autres ou à L'.

10. Composé selon une ou plusieurs des revendications 1 à 9, **caractérisé en ce que** L' est sélectionné parmi le groupe qui est constitué par le monoxyde de carbone, le monoxyde d'azote, les cyanures d'alkyle, les cyanures d'aryle, les isocyanures d'alkyle, les isocyanures d'aryle, les amines, les phosphines, les phosphites, les arsines, les stibines, les hétérocycles qui contiennent de l'azote, les carbènes, l'hydrure, le deutérure, les halogénures F⁻, Cl⁻, Br et I⁻, les alkyl- ou arylacétylures, le cyanure, le cyanate, l'isocyanate, le thiocyanate, l'isothiocyanate, les alcoolates aliphatiques ou aromatiques, les thioalcoolates aliphatiques ou aromatiques, les amides, les carboxylates, les groupes aryle, O²⁻, S²⁻, les carbures, les nitrènes, les diamines, les imines, les diphosphines, les 1,3-dicétonates qui sont dérivés à partir des 1,3-dicétones, les 3-cétonates qui sont dérivés à partir des 3-cétoesters, les carboxylates qui sont dérivés à partir des acides aminocarboxyliques, les salicyliminates qui sont dérivés à partir des salicylimines, les dialcoolates, les dithiolates, les borates d'hétérocycles qui contiennent de l'azote et des ligands monoanioniques bidentés, qui, avec le métal, forment un cycle à cinq éléments ou un cycle à six éléments cyclométallé qui comporte au moins une liaison métal-carbone.

11. Procédé pour la préparation d'un composé selon une ou plusieurs des revendications 1 à 10, comprenant la réaction des ligands libres correspondants avec des alcoolates de métaux de la formule (55), avec des cétocétonates de métaux de la formule (56), avec des halogénures de métaux de la formule (57), avec des complexes de métaux dimériques de la formule (58) ou avec des composés de métaux qui sont porteurs à la fois de radicaux alcoolate et/ou halogénure et/ou hydroxyle et également de radicaux cétocétonate : 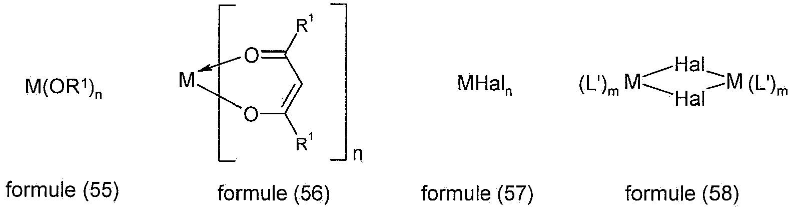 dans lesquelles les symboles M, m, n et R¹ présentent les significations qui ont été indiquées selon la revendication 1 et Hal = F, Cl, Br ou I.

12. Formulation comprenant au moins un composé selon une ou plusieurs des revendications 1 à 10 et au moins un solvant.

13. Utilisation d'un composé selon une ou plusieurs des revendications 1 à 10 ou d'une formulation selon la revendication 12 dans un dispositif électronique ou pour la génération d'oxygène singlet, lors d'une photocatalyse ou dans des capteurs d'oxygène.

14. Dispositif électronique contenant au moins un composé selon une ou plusieurs des revendications 1 à 10, de préférence sélectionné parmi le groupe qui est constitué par les dispositifs électroluminescents organiques, les circuits intégrés organiques, les transistors à effet de champ organiques, les transistors à film mince organiques, les transistors à émission de lumière organiques, les cellules solaires organiques, les détecteurs optiques organiques, les photorécepteurs organiques, les dispositifs à extinction de champ organiques, les cellules électrochimiques à émission de lumière ou les diodes laser organiques.

15. Dispositif électronique selon la revendication 14, lequel est un dispositif électroluminescent organique, **caractérisé en ce que** le composé selon une ou plusieurs des revendications 1 à 10 est utilisé en tant que composé d'émission dans une ou plusieurs couche(s) d'émission, en option en combinaison avec un matériau de matrice.
